# EUROPEAN PATENT APPLICATION

(11) **EP 2 546 387 A1**
(43) Date of publication of application: **16.01.2013**
(21) Application number: 12187699.9
(22) Date of filing: 23.03.2009
(51) Int. Cl.: C23C 28/00, C23F 1/18, C23F 11/14, H05K 3/38, C23C 22/20, H05K 3/12

(54) **Adhesion promotion of metal to laminate with a multi-functional compound**

(30) Priority: 21.03.2008 US 38434
(62) Divisional of application: 09723171.6
(71) Applicant: Enthone, Inc., West Haven, CT 06516 (US)
(72) Inventor: Antonellis, Theodore, West Haven, 06516 (US); Sun, Shenliang, West Haven, 06516 (US); Walch, Eric, 40764 Langenfeld (DE); Owei, Abayomi I., Rancho Cucamonga, CA California 91730 (US); Rasmussen, Hanna, 51399 Burscheid (DE); Abys, Joseph A., West Haven Connecticut 06516 (US)
(74) Representative: UEXKÜLL & STOLBERG

(57) **Abstract**

An adhesion promotion composition and method for enhancing adhesion between a copper conducting layer and a dielectric material during manufacture of a printed circuit board. The adhesion promotion composition comprises a multi-functional compound comprising a first functional group and a second functional group, wherein the first functional group is an aromatic heterocyclic compound comprising nitrogen and the second functional group is selected from the group consisting of vinyl ether, amide, thiamide, amine, carboxylic acid, ester, alcohol, silane, alkoxy silane, and combinations thereof.

## Description

### FIELD OF THE INVENTION

This invention generally relates to improving adhesion between a metal surface and a dielectric material in the manufacture of electronics. More specifically, the invention relates to a method of improving the adhesion between a metal surface and an organic material and/or improving the adhesion between a metal surface and a glass fiber.

### BACKGROUND OF THE INVENTION

A multilayer circuit board (MLB) has, among other things, a number of metal layers defining circuit patterns and a number of insulating layers there-between. The metal layers defining circuit patterns today are typically formed from copper, and the insulating layers are typically formed from a resinous glass fiber-impregnated ("pre-preg") dielectric material. These respective layers can have a wide variety of thicknesses. For example, they can be on the order of only micrometers thick or much thicker.

In manufacturing MLBs, it is desirable to enhance the adhesion between the conducting and insulating layers to avoid delamination in subsequent manufacturing operations or in service. So called "black oxide" processes had been used for years which created a strongly adherent copper oxide layer to which an insulating layer would adhere better. Black oxide processes have, for most of the industry, been replaced by processes such as described in U.S. Pat. Nos. 5,800,859 and 7,232,478 involving formation of an organometallic conversion coating (OMCC). These OMCC processes involve exposing the copper circuit layer to an adhesion promotion solution, which contains various components including an oxidizer, an inhibitor, and a mineral acid. OMCC processes provide a "structured" surface which allows mechanical adhesion to occur during the lamination process. The inhibitor, which is an azole, concentrates copper(1) ion at the surface by forming an insoluble azole-copper(I) complex over the copper surface. The capper(I) ion-based complex provides better mechanical adhesion to organic laminates than copper(II) oxide. The inhibitor also passivates the copper surface to further inhibit copper corrosion.

The PCB industry is migrating away from Pb-containing solders toward lead-free solders as required by the Restriction of Hazardous Substances (RoHS) directive which became law in Europe on July 1,2006. Pb-free solders require higher reflow temperatures than Pb-containing solders. For example, typical reflow temperatures range from 260°C to 270°C for Pb-free solders, as opposed to 220°C for Pb-containing solders. The higher temperatures challenge many of the materials utilized for the assembly of electronic components, including current inner-layer processes such as OMCC processes. It is thought that delamination of copper-laminate composites can occur at the required higher reflow temperatures due to mismatch of coefficiencies of thermal expansion (CTE) between metals and polymer materials.

The coating industry has also been searching for effective adhesion promoters to improve the adhesion between organic coatings and metal substrates, for example, adhesion of solder mask or liquid photoimageable solder mask (LPSM) to the surface of a board.

### SUMMARY OF THE INVENTION

Briefly, the invention is directed to an adhesion promotion composition for enhancing adhesion between a copper conducting layer and a dielectric material during manufacture of a printed circuit board. The adhesion promotion composition comprises a multi-functional compound comprising a first functional group and a second functional group, wherein (1) the first functional group is selected from the group consisting of an aromatic heterocyclic compound comprising nitrogen and an aliphatic amine, and (2) the second functional group is selected from the group consisting of vinyl ether, amide, thiamide, amine, carboxylic acid, ester, alcohol, silane, alkoxy silane, and combinations thereof; a surfactant; an acid; and an alcohol solvent.

The invention is further directed to a process for enhancing adhesion between a copper conducting layer and a dielectric material during manufacture of a printed circuit board. The process comprises exposing the copper conducting layer to an adhesion promotion composition comprising a multi-functional compound comprising a first functional group and a second functional group, wherein (1) the first functional group is selected from the group consisting of an aromatic heterocyclic compound comprising nitrogen and an aliphatic amine and (2) the second functional group is selected from the group consisting of vinyl ether, amide, thiamide, amine, carboxylic acid, ester, alcohol, silane, alkoxy silane, and combinations thereof, wherein the first functional group interacts with the surface of the copper conducting layer to form a copper(I) rich organometallic adhesive film over the surface of the copper conductive substrate.

Other features of the invention will be in part apparent and in part pointed out hereinafter.

### BRIEF DESCRIPTION OF THE FIGURES

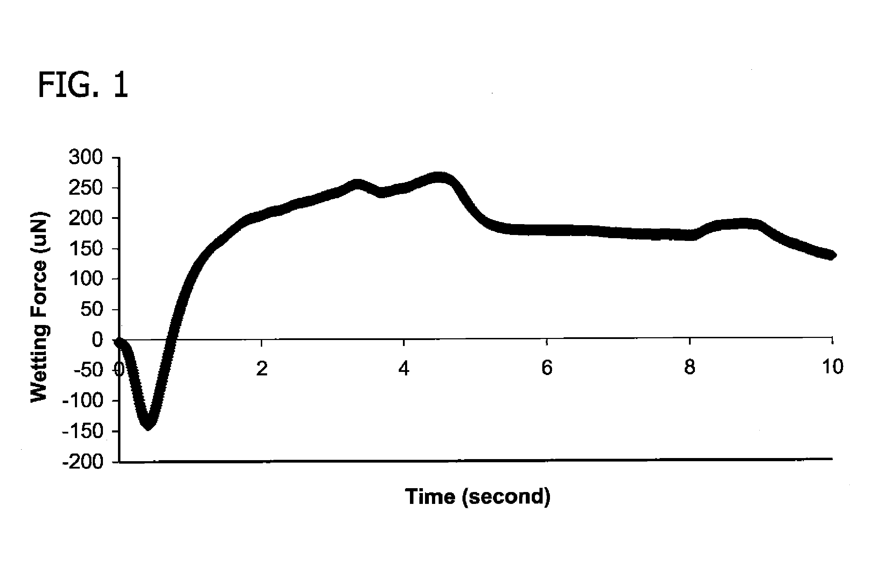

] FIG. 1 is a graph showing a wetting curve of coating applied from adhesion promotion composition of Example 1.

FIG. 2 is a graph showing a wetting curve of coating applied from adhesion promotion composition of Example 2.

FIG. 3 is an XPS spectra of the region from 920 to 965 eV for analyzing copper on the surface of the copper sample for (A) the surface treated with the adhesion promotion composition of Example 1, (B) the coating from (A) after reflow, (C) the surface treated with the adhesion promotion composition of Example 2, and (D) the coating from (C) after reflow.

### DETAILED DESCRIPTION OF THE EMBODIMENT(S) OF THE INVENTION

The present invention is directed to an adhesion promotion composition and a method of using the composition to treat a metal surface, which treatment results in enhanced adhesion between the metal surface and a dielectric material. For example, the composition can be used to treat a copper conductive surface, e.g., a copper foil, to promote adhesion to resinous glass fiber-impregnated ("pre-preg") dielectric material in the manufacture of printed circuit boards. Although this composition finds particular use in printed circuit board manufacture, including manufacture of multi-layer boards, the composition of the invention may improve the adhesion between dielectric materials and metal substrates in a variety of applications.

Appropriate dielectric substrate materials that may be treated to improve adhesion to metal surface (e.g., copper foil) in printed circuit board manufacture include, for example, glass fiber reinforced epoxy resin substrates (i.e., layers of fibrous materials bonded together under heat and pressure with a thermosetting resin). In printed circuit board manufacture, the epoxy resins are typically derived from a reaction between epichlorohydrin and bisphenol-A. The invention is applicable to a wide variety of epoxy resins typically used in PCB manufacture. In general, an epoxy resin substrate comprises a continuous-filament glass cloth bonded with an epoxy-resin system. Specific examples of epoxy resin substrates include the following: G-10, which is a substrate comprising epoxy resin reinforced with glass fiber cloth sheets; FR-4, which is a self-extinguishing substrate similar to G-10; G-11, which is a glass cloth and epoxy mixture; and FR-5, which is a flame-resistant version of G-11. FR-4 substrates can be reinforced with ceramic particles, such as those available from Rogers Corporation (Chandler, AZ).

Other resins that may be reinforced with glass fiber include acrylic resins, such as polymethyl acrylate and polymethyl methacrylate. Still other resins include polyphenylene ether, cyanate ester, and bismaleimide/triazine.

Additional dielectric materials which can be substrates include ceramics, glass, Teflon, glass fiber-reinforced Teflon, ceramic-reinforced Teflon, polystyrene, and polyimide (for flexible board applications).

Most adhesion promotion compositions known in the art enhance adhesion between a metal surface and a pre-preg insulating layer by roughening the surface of the metal, thereby rendering the surface of the metal amenable to mechanical adhesion through van der Waal's forces and the like. The adhesion promotion composition of the present invention does not rely solely on mechanical forces to adhere the metal surface and pre-preg insulating layer together. Rather, in one embodiment, the adhesion promotion composition comprises a multi-functional compound capable of forming chemical bonds to resinous organic dielectric material typically used in pre-preg insulating layers. In one embodiment, the adhesion promotion composition comprises a multi-functional compound capable of forming chemical bonds to the glass fibers also typically present in pre-preg insulating layers. In one embodiment, the adhesion promotion composition comprises more than one such multi-functional compound, that is, the adhesion promotion composition comprises a mixture of multi-functional compounds. In some embodiments, the adhesion promotion composition comprises two or more multi-functional compounds, wherein each multi-functional compound is capable of bonding to the same materials, or each multi-functional compound is capable of bonding to different materials. For example, the adhesion promotion composition can comprise a first multi-functional compound capable of forming chemical bonds to the resinous organic dielectric material in the pre-preg insulating layer and a second multi-functional compound capable of forming chemical bonds to the glass fibers in the pre-preg insulating layer. The multi-functional compounds bonded to the resinous organic dielectric material and/or glass fibers provide a strongly adhesive layer or film between the metal surface and pre-preg insulating layer. The adhesive film which forms between the metal surface and pre-preg insulating layer is expected to be more durable than films which rely solely on mechanical adhesion and more resistant to delamination at the higher temperatures required for reflow of Pb-free solders.

The multi-functional compounds included in the adhesion promotion composition of the present invention comprise a first functional group and a second functional group. In some embodiments, the multi-functional compound comprising additional functional group, i.e., a third functional group, a fourth functional group, etc. The multi-functional compounds of the present invention are therefore bi-functional, tri-functional, tetra-functional, or more. In compounds comprising two or more second functional groups, the plural second functional groups may be the same or different. The two or more second functional groups may be capable of bonding to the same types of materials in some embodiments. In some embodiments, the two or more second functional groups may be capable of bonding to different types of materials. The first functional group roughens the surface of the metal substrate and forms an organometallic conversion coating over the surface of the metal substrate. First functional groups capable of forming organometallic conversion coatings include aromatic heterocyclic compounds comprising nitrogen. The second functional group is compatible with and bonds to resinous organic dielectric material and/or glass fibers typically used in pre-preg insulating layers in printed circuit board manufacture. Second functional groups capable of bonding with resinous organic dielectric material and/or glass fibers may be selected from the group consisting of vinyl ether, amide, amine, carboxylic acid, ester, alcohol, silane, and alkoxy silane. In some embodiments, the adhesion promotion compound may comprise a combination of two or more such second functional groups. Preferably, the first functional group and second functional group are non-reactive with each other.

In some embodiments, the first functional group comprises an aromatic heterocyclic compound comprising nitrogen. In some embodiments, the first functional group comprises an aliphatic amine. The first functional group interacts with copper(I) ions on the surface of the copper conducting layer and copper(II) ions in solution. Interaction with copper(I) ions forms a film comprising insoluble copper(I)-based organometallics on the surface of the copper conducting layer, i.e., a film that has become known as an organometallic conversion coating (OMCC). The first functional groups chelates copper(II) ions in solution. These interactions result in the formation of a protective film on the surface of the copper conductive layer which is enriched in copper(I) ions, thereby increasing the ratio of copper(I) ions to copper(II) ions on the surface of the copper conducting layer. This film forms a micro-roughened surface morphology on the conducting copper layer. This micro-roughened copper surface promotes adhesion with the subsequently applied pre-preg insulating layer. Although this discussion focuses on a multi-functional molecule applicable for bonding to copper substrates, the multi-functional molecule can form an organometallic film over other metal surfaces, such as silver, nickel, iron, cobalt, zinc, and tin.

The aromatic heterocyclic compound comprising nitrogen preferably comprises a 5-membered aromatic ring (an azole). The ring can be substituted at a carbon atom, a nitrogen atom, or both. The substituent may be the second functional group capable of bonding to the resinous organic dielectric material and/or glass fibers, Preferably, the ring is substituted with the second functional group at a carbon atom. The ring may be substituted at a nitrogen atom, but preferably at least one nitrogen atom is available to interact with copper(I) ions and copper(II) ions in a manner which forms a copper(I) rich organometallic adhesive film over the surface of the metal substrate. Even more preferably, at least one nitrogen atom is available that is bonded to an acidic hydrogen atom, such that the aromatic heterocycle may become deprotonated and the resultant negatively charged aromatic heterocyle is available to interact with copper(I) ions and copper(II) ions in a manner which forms a copper(I) rich organometallic adhesive film over the surface of the metal substrate. The ring may be fused to aromatic or cycloalkyl groups, which may be homocyclic or heterocyclic. In one embodiment, the aromatic heterocycle comprises a substituted 5-membered ring. In one embodiment, the aromatic heterocycle comprises a 5-membered ring that is fused to a 6-membered ring. Exemplary azoles which can be further substituted with the second functional group are shown in Table I.

**Table I. Azoles**

| Name | Structure | Name | Structure |
|---|---|---|---|
| Pyrrole (1H-azole) | 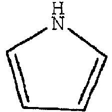 | Benzimidazole (1,3-benzodiazole) | 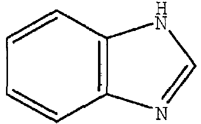 |
| Imidazole (1,3-diazole) | 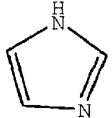 | Indazole (1,2-benzodiazole) | 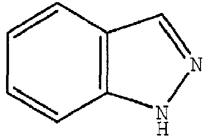 |
| Pyrazole (1,2-diazole) | 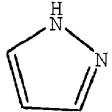 | 1H-Benzotriazole | 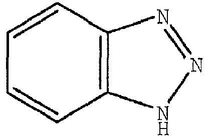 |
| 1,2,3-triazole | 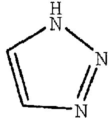 | 2H-Benzotriazole | 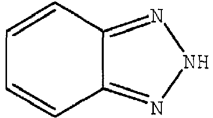 |
| 1,2,4-triazole | 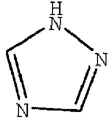 | Imidazo[4,5-b]pyridine | 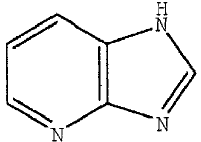 |
| Tetrazole | 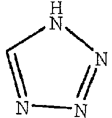 | Purine (7H-Imidazo(4,5-d)pyrimidine) | 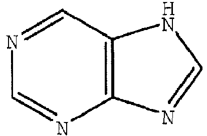 |
| Isoindole | 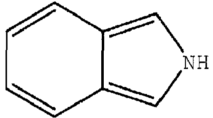 | Pyrazolo[3,4-d]pyrimidine | 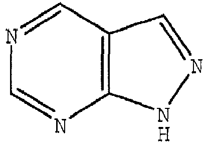 |
| Indole (1H-Benzo[b]pyrrole) | 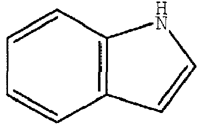 | Triazolo[4,5-d]pyrimidine | 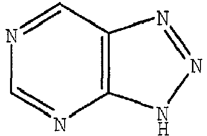 |

Benzotriazole is known in the art for its anti-corrosion properties, especially for its ability to protect copper surfaces from corrosion. Preferably, the aromatic heterocyclic compound comprising nitrogen has chemical properties substantially similar to benzotriazole. Without being bound to a particular theory, it is thought that the pKa of acidic -NH moiety in benzotriazole is advantageous for forming organometallic corrosion coatings. Benzotriazole has a pKa of about 8.4. Preferably, the aromatic heterocyclic compound has a pKa which is similar to benzotriazole, for example, the aromatic heterocycle comprising nitrogen has a pKa within about 3 pH units of benzotriazole, such as between about 5 and about 11, but compounds having pKa slightly outside this range are potentially applicable. Preferably, the pKa is between about 5 and about 13, such as between about 5 and about 11, such as between about 6 and about 10, more preferably about 7.5 and about 9.0, such as, for example, between about 8.0 and about 8.8. Importantly, the aromatic heterocyclic compound comprising nitrogen interacts with copper(I) ions and copper(II) ions in a manner which forms a copper(I) rich organometallic adhesive film over the surface of the metal substrate. The aromatic heterocyclic compound comprising nitrogen preferably forms the organometallic film under strongly acidic conditions typically associated with adhesion promotion compositions and is resistant to acid. Preferred aromatic heterocyclic compounds comprising nitrogen having these properties include imidazole, triazole, pyrazole, benzimidazole, purine, imidazo[4,5-b]pyridine, and benzotriazole.

Aromatic heterocycles comprising acidic -NH groups, such as imidazoles, benzotriazoles, and purines, having pKas within the preferred ranges may become de-protonated and complex with copper ions, thereby forming insoluble copper complexes even at the preferred highly acidic solutions having pHs below about 1.0. Preferred functional groups such as amides and carboxylic acids are non-reactive with the aromatic compound. These functional groups are therefore available for reaction with epoxies and polyimides under the process conditions typically used for laminating pre-pregs with copper.

In some embodiments, the multi-functional compound is a substituted azole fused to a 6-membered aromatic ring. Accordingly, the multi-functional compound can have either of the following general structures (Ia) or (Ib): 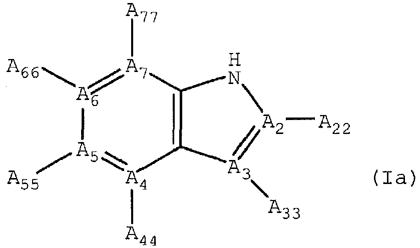 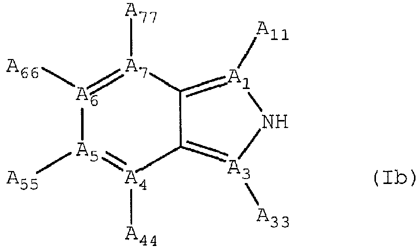 wherein:
A₁, A₂, A₃, A₄, A₅, A₆, and A₇ are carbon atoms or nitrogen atoms and the sum of nitrogen atoms from A₁, A₂, A₃, A₄, A₅, A₆, and A₇ is 0, 1, 2, or 3;
A₁₁, A₂₂, A₃₃, A₄₄, A₅₅, A₆₆, and A₇₇ are selected from the group consisting of electron pair, hydrogen, substituted or unsubstituted alkyl, substituted or unsubstituted aryl, substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane; and
at least one of A₁₁, A₂₂, A₃₃, A₄₄, and A₅₅ is selected from the group consisting of substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane.

The description of the vinyl ether, amide, amine, carboxylic acid, ester, alcohol, silane, or alkoxy silane as being substituted or unsubstituted is intended to encompass embodiments wherein the vinyl ether, amide, amine, carboxylic acid, ester, alcohol, silane, or alkoxy silane is bonded directly to the aromatic heterocyclic compounds comprising nitrogen, embodiments wherein the vinyl ether, amide, amine, carboxylic acid, ester, alcohol, silane, or alkoxy silane is bonded through a linking group typically an alkyl, alkenyl, alkynyl, or aryl group, and embodiments wherein vinyl ether, amide, amine, carboxylic acid, ester, alcohol, silane, or alkoxy silane is bonded through a linking group that is further substituted with other moieties that are optionally functional in the sense that they are capable of bonding to the resinous organic dielectric material and/or glass fiber in a pre-preg insulating layer. The vinyl ether, amide, amine, carboxylic acid, ester, alcohol, silane, or alkoxy silane in all of these embodiments is capable of bonding to the resinous organic dielectric material and/or glass fiber in a pre-preg insulating layer.

In some embodiments, the multi-functional compound is selected from among substituted purines, substituted benzotriazoles, and substituted imidazo[4,5-b]pyridines. Accordingly, the multi-functional molecules can have the following general structures (II) purines, (III) benzotriazoles, and (IV) imidazo[4,5-b]pyridines: 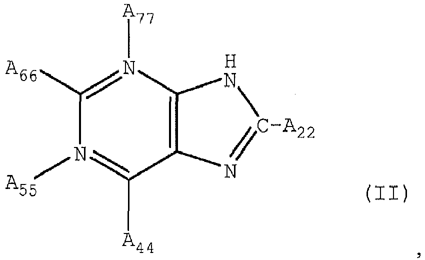 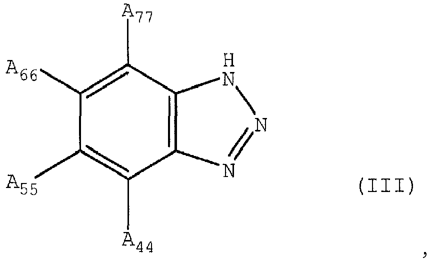 or 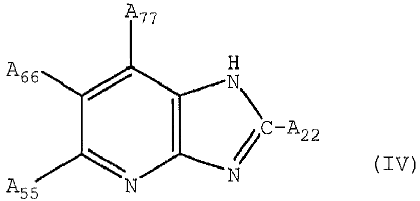 wherein A₂₂, A₄₄, A₅₅, A₆₆, and A₇₇ are as defined in connection with structures (Ia) and (Ib).

In some embodiments, the multi-functional compound is a substituted 5-membered azole ring that is not fused to any additional ring structure. Accordingly, the multi-functional compound can have the following general structure (V): 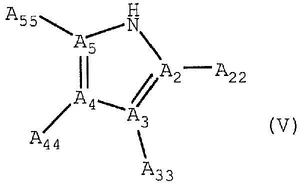 wherein:
A₂, A₃, A₄ and A₅ are carbon atoms or nitrogen atoms and the sum of nitrogen atoms from A₂, A₃, A₄ and A₅ is 0, 1 or 2;
A₂₂, A₃₃, A₄₄, and A₅₅ are selected from the group consisting of hydrogen, substituted or unsubstituted alkyl, substituted or unsubstituted aryl, substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane; and
at least one of A₂₂, A₃₃, A₄₄, and A₅₅ is selected from the group consisting of substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane.

In some embodiments, the first functional group is an aliphatic amine. Applicable aliphatic amines include primary amines, secondary amines, and tertiary amines.

Exemplary primary amines applicable include aminoethane, 1-aminopropane, 2-aminopropane, 1-aminobutane, 2-aminobutane, 1-amino-2-methylpropane, 2-amino-2-methylpropane, 1-aminopentane, 2-aminopentane, 3-aminopentane, neo-pentylamine, 1-aminohexane, 1-aminoheptane, 2-aminoheptane, 1-aminooctane, 2-aminooctane, 1-aminononane, 1-aminodecane, 1-aminododecane, 1-aminotridecane, 1-aminotetradecane, 1-aminopentadecane, 1-atninohexadecane, 1-aminoheptadecane, and 1-aminooctadecane.

Exemplary secondary amines include diethylamine, dipropylamines, dibutylamines, dipentylamines, dihexylamines, diheptylamines, dioctylamines, dinonylamines, didecylamines, diundecylamines, didodecylamines, ditridecylamines, ditetradecylamines, dihexadecylamines, dioctadecylamines, and others.

Exemplary tertiary amines include triethylamine, tripropylamines, tributylamines, tripentylamine, trihexylamines, triheptylamines, trioctylamines, trinonylamines, tridecylamines, triundecylamines, tridodecylamines, tritridecylamines, tritetradecylamines, trihexadecylamines, trioctadecylamines, and others.

Also applicable are organic functional molecules comprising two or more amine, such as ethylenediamine, 2-(Diisopropylamino)ethylamine, N,N'-Diethylethylenediamine, N-Isopropylethylenediamine, N-Methylethylenediamine, N,N-Dimethylethylenediamine, 1-dimethylamino-2-propylamine, 3-(Dibutylamino)propylamine, 3-(Diethylamino)propylamine, 3-(Dimethylamino)-1-propylamine, 3-(Methylamino)propylamine, N-Methyl-1,3-diaminopropane, N,N-Diethyl-1,3-propanediamine, and others.

Multi-functional compounds for use in the adhesion promotion composition of the present invention comprising aliphatic amines as the first functional group are preferably substituted at a carbon atom with the second functional groups defined herein. In some embodiments, the second functional group may be bonded to a nitrogen atom on the aliphatic amine. In these embodiments, preferably at least one acidic amine comprising the moiety, -NH, remains available for forming an organometallic conversion coating.

The second functional group is compatible with and bonds to resinous organic dielectric material and/or glass fibers typically used in pre-preg insulating layers in printed circuit board manufacture. The second functional group may be selected from the group consisting of vinyl ether, amide, amine, carboxylic acid, ester, alcohol, silane, and alkoxy silane. In one embodiment, the second functional group is capable of chemically bonding to epoxy and polyimide resins. Second functional groups useful in this regard include vinyl ether, amide, amine, carboxylic acid, ester, and alcohol. The adhesion promotion composition is applicable to other fields where an organic material is applied to a metal substrate. Accordingly, these second functional groups may bond to organic materials such as acrylate resins, silicone, and polyurethane. In one embodiment, the second functional group is compatible with and bonds to the glass fibers. The functional groups useful in this regard include silane and alkoxy silane. The adhesion promotion composition may comprise a combination of a multi-functional compound having a second functional group capable of bonding to epoxy and polyimide resins and a multi-functional compound having a second functional group capable of bonding to glass fibers.

In one embodiment, the second functional group is vinyl ether, which has been found suitable for bonding to acrylate resins. The vinyl ether can have the following structure (VI): 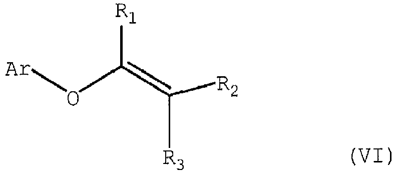 wherein
Ar represents a moiety comprising an aromatic heterocyclic compound comprising nitrogen; and
R₁, R₂, and R₃ are each selected from among hydrogen, a substituted or unsubstituted alkyl, and a substituted or unsubstituted aryl. The alkyl typically comprises between about one and about eight carbon atoms, more typically between about one and about four carbon atoms, i.e., methyl, ethyl, n-propyl, iso-propyl, n-butyl, sec-butyl, iso-butyl, and tert-butyl. The aryl typically comprises a phenyl, benzyl, naphthyl, or alkyl substituted versions thereof, i.e., tolyl, xylyl, mesityl. The vinyl ether may be bonded directly to the aromatic heterocyclic compound or may be bonded through a linkage, which may be a lower alkyl, such as methylene, ethylene, or propylene, or an aryl, such as phenyl or benzyl. In a preferred embodiment, R₁, R₂, and R₃ are hydrogen.

Preferred aromatic heterocycles for bonding to vinyl ethers include benzimidazole, indazole, imidazole, and triazole. Exemplary compounds comprising vinyl ethers bonded to aromatic heterocycles comprising nitrogen include the compounds in the following Table II:

**Table II. Multi-functional Compounds Comprising Vinyl Ethers**

| Name | Structure |
|---|---|
| 2-(vinyloxy)-1H-benzimidazole | 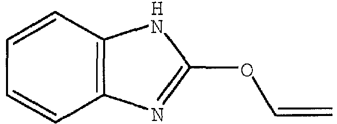 |
| 2-(vinyloxymethyl)-1H-benzimidazole | 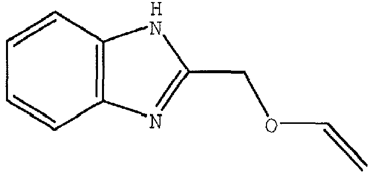 |
| 3-(vinyloxy)-2H-indazole | 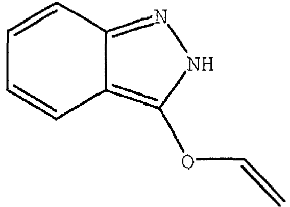 |
| 2-(vinyloxy)-1H-imidazole | 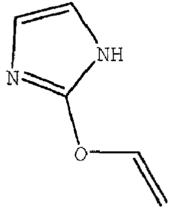 |
| 2-(vinyloxymethyl)-1H-imidazole | 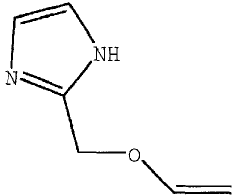 |
| 3-(vinyloxy)-1H-1,2,4-triazole | 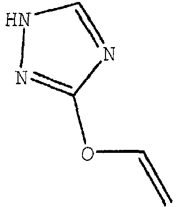 |

In one embodiment, the second functional group is amine, which has been found suitable for bonding to epoxy resins and polyimide resins. The amine can have the following structure (VII): 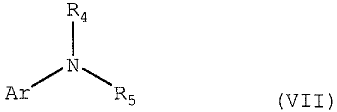 wherein
Ar represents a moiety comprising an aromatic heterocyclic compound comprising nitrogen; and
R₄ and R₅ are each selected from among hydrogen, a substituted or unsubstituted alkyl, and a substituted or unsubstituted aryl. The alkyl typically comprises between about one and about eight carbon atoms, more typically between about one and about four carbon atoms, i.e., methyl, ethyl, n-propyl, iso-propyl, n-butyl, sec-butyl, iso-butyl, and tert-butyl. The aryl typically comprises a phenyl, benzyl, naphthyl, or alkyl substituted versions thereof, i.e., tolyl, xylyl, mesityl. The amine may be bonded directly to the aromatic heterocyclic compound or may be bonded through a linkage, which may be a lower alkyl, having from one to four carbons, such as methylene, ethylene, or propylene, butylene, or an aryl, such as phenyl or benzyl, with alkyl linkage groups being preferred. Preferably, the amine is a primary amine or a secondary amine. In one embodiment, R₄ and R₅ arc both hydrogen. In one embodiment, one of R₄ and R₅ is hydrogen, and one of R₄ and R₅ is phenyl.

Preferred aromatic heterocycles for bonding to amines include purine, benzotriazole, benzimidazole, imidazole, and pyrazole. Exemplary compounds comprising amines bonded to aromatic heterocycles comprising nitrogen include the compounds in the following Table III:

**Table III. Bi-functional Compounds Comprising Amines**

| Name | Structure |
|---|---|
| 6-phenylamino-purine | 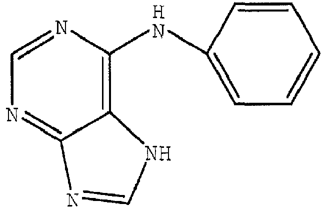 |
| 6-benzylamino-purine | 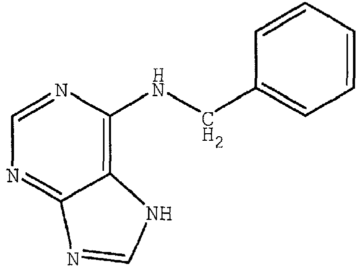 |
| 6-methylamine-purine | 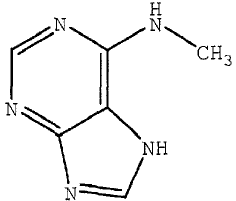 |
| 6-dimethyl-purine | 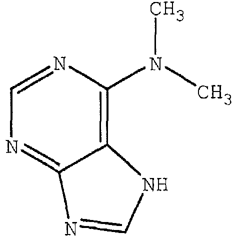 |
| 9H-purine-2,6-diamine | 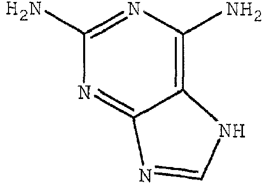 |
| α-metlyl-N-phenyl-1H-benzotriazole-1-methanamine | 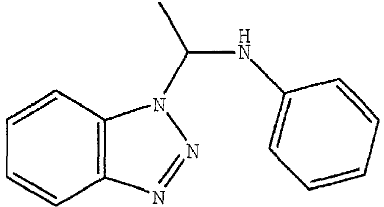 |
| 2-(2-aminoethyl)benzimidazole | 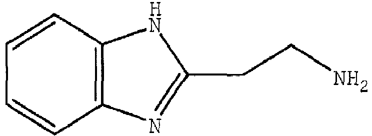 |
| 2-(2-aminophenyl)-1H-benzimidazol | 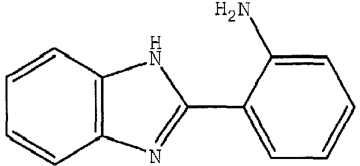 |
| Histamine | 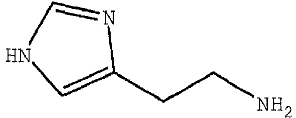 |
| 1-methylhistamine | 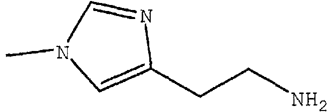 |
| 3-methylhistamine | 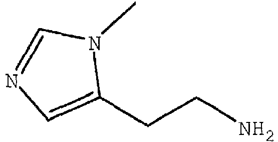 |
| 1-(3-aminopropyl)imidazole | 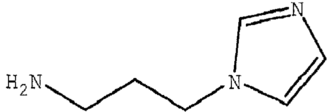 |
| 3-amino-pyrazole | 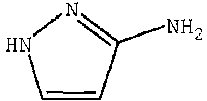 |

In one embodiment, the second functional group is amide or a thiamide, which has been found suitable for bonding to epoxy resins. The amide can have the following structure (VIII): 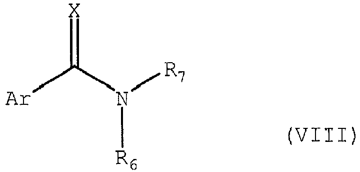 wherein
Ar represents a moiety comprising an aromatic heterocyclic compound comprising nitrogen
X is an oxygen atom or a sulfur atom; and
R₆ and R₇ are each selected from among hydrogen, a substituted or unsubstituted alkyl, and a substituted or unsubstituted aryl. The alkyl typically comprises between about one and about eight carbon atoms, more typically between about one and about four carbon atoms, i.e., methyl, ethyl, n-propyl, iso-propyl, n-butyl, sec-butyl, iso-butyl, and tert-butyl. The aryl typically comprises a phenyl, benzyl, naphthyl, or alkyl substituted versions thereof, i.e., tolyl, xylyl, mesityl. The amide may be bonded directly to the aromatic heterocyclic compound or may be bonded through a linkage, which may be a lower alkyl, having from one to four carbons, such as methylene, ethylene, or propylene, butylene, or an aryl, such as phenyl or benzyl, with alkyl linkage groups being preferred. In one embodiment, R₆ and R₇ are both hydrogen.

Preferred aromatic heterocycles for bonding to amides and thiamides include purine and benzotriazole. Exemplary compounds comprising amides and thiamides bonded to aromatic heterocycles comprising nitrogen include the compounds in the following Table IV:

**Table IV. Multi-functional Compounds Comprising Amides**

| Name | Structure |
|---|---|
| 5-acetamide-benzotriazole | 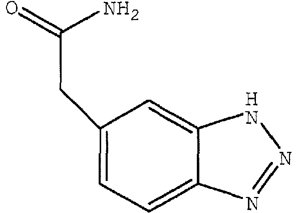 |
| 8-para-methylbenzamide-purine | 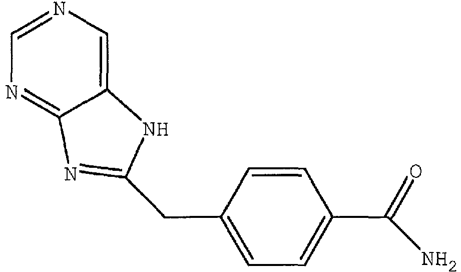 |
| Benzotriazole-1-carboxamide | 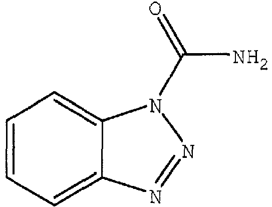 |
| N-(2-propenyl)-1H-benzotriazole-1-carbothiamide | 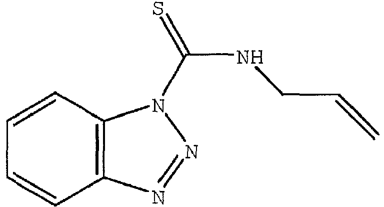 |
| N-phenyl-1H-benzotriazole-1-carboxamide | 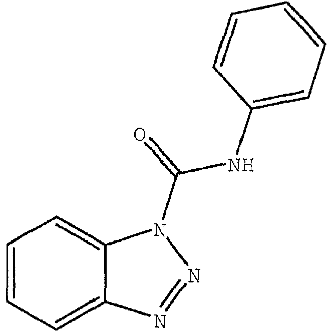 |

In one embodiment, the second functional group is a carboxylic acid, which has been found suitable for bonding to epoxy resins and polyimide resins. The carboxylic acid can have the following structure (IX): 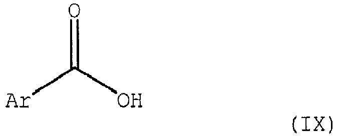 wherein Ar represents a moiety comprising an aromatic heterocyclic compound comprising nitrogen. The carboxylic acid may be bonded directly to the aromatic heterocyclic compound or may be bonded through a linkage, which may be a lower alkyl, such as methylene, ethylene, or propylene, or an aryl, such as phenyl or benzyl. The carboxylic acid may be bonded directly to the aromatic heterocyclic compound or may be bonded through a linkage, which may be a lower alkyl, having from one to four carbons, such as methylene, ethylene, or propylene, butylene, or an aryl, such as phenyl or benzyl, with alkyl linkage groups being preferred.

Preferred aromatic heterocycles for bonding to carboxylic acids include benzotriazole, imidazole, and pyrazole. Exemplary compounds comprising carboxylic acids bonded to aromatic heterocycles comprising nitrogen include the compounds in the following Table V:

**Table V. Multi-functional Compounds Comprising Carboxylic Acids**

| Name | Structure |
|---|---|
| Benzotriazole-4-carboxylic acid | 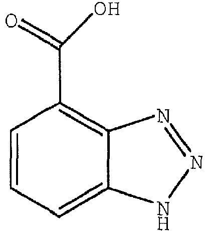 |
| Benzotriazole-5-carboxylic acid | 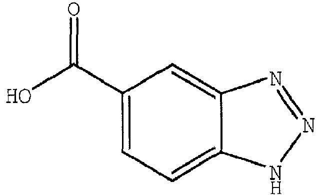 |
| Imidazole-4-acetic acid | 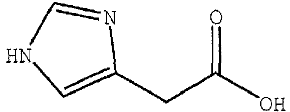 |
| 1H-pyrazole-4-carboxylic acid | 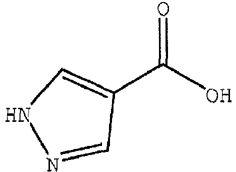 |
| 1H-pyrazole-5-carboxylic acid | 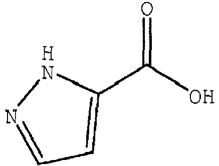 |

In one embodiment, the second functional group is ester. The ester can have the following structures (Xa) or (Xb): 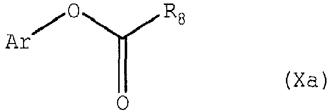 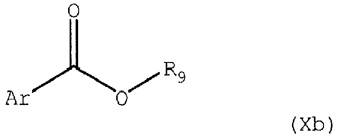 wherein
Ar represents a moiety comprising an aromatic heterocyclic compound comprising nitrogen; and
R₈ and R₉ are selected from among hydrogen, a substituted or unsubstituted alkyl, and a substituted or unsubstituted aryl. The alkyl typically comprises between about one and about eight carbon atoms, more typically between about one and about four carbon atoms, i.e., methyl, ethyl, n-propyl, iso-propyl, n-butyl, sec-butyl, iso-butyl, and tert-butyl. The aryl typically comprises a phenyl, benzyl, naphthyl, or alkyl substituted versions thereof, i.e., tolyl, xylyl, mesityl. The ester may be bonded directly to the aromatic heterocyclic compound or may be bonded through a linkage, which may be a lower alkyl, having from one to four carbons, such as methylene, ethylene, or propylene, butylene, or an aryl, such as phenyl or benzyl, with alkyl linkage groups being preferred. In one embodiment, the ester is structure (V), and R₈ is a methyl group.

Preferred aromatic heterocycles for bonding to esters include benzotriazole and imidazole. Exemplary compounds comprising esters bonded to aromatic heterocycles comprising nitrogen include the compounds in the following Table VI:

**Table VI. Multi-functional Compounds Comprising Esters**

| Name | Structure |
|---|---|
| Methyl 1H-benzotriazole-1-carboxylate | 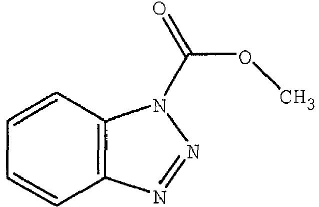 |
| Phenyl 1H-1,2,3-benzotriazole-5-carboxylate | 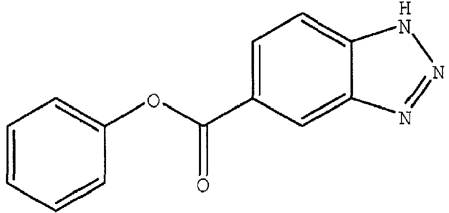 |
| 1-(benzyloxycarbonyl) benzotriazole | 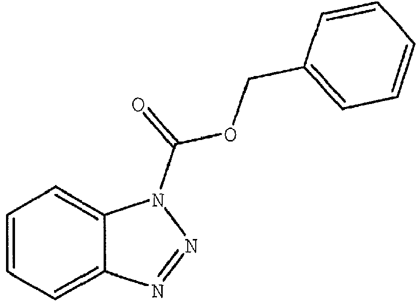 |
| 1H-imidazole-4,5-dicarboxylic acid dimethyl ester | 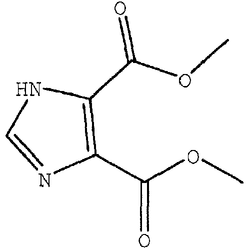 |

In one embodiment, the second functional group is an alcohol, which has been found suitable for bonding to epoxy resins. The alcohol can have the following structure (XI):

Ar-OH (XI)

wherein Ar represents a moiety comprising an aromatic heterocyclic compound comprising nitrogen. The alcohol may be bonded directly to the aromatic heterocyclic compound or may be bonded through a linkage, which may be a lower alkyl, having from one to four carbons, such as methylene, ethylene, or propylene, butylene, or an aryl, such as phenyl or benzyl, with alkyl linkage groups being preferred.

Preferred aromatic heterocycles for bonding to alcohols include benzotriazole, benzimidazole, imidazole, and pyrazole. Exemplary compounds comprising alcohols bonded to aromatic heterocycles comprising nitrogen include the compounds in the following Table VII:

**Table VII, Multi-functional Compounds Comprising Alcohols**

| Name | Structure |
|---|---|
| 4-hydroxy-1H-benzotriazole | 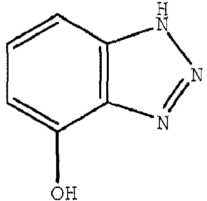 |
| 2-(2-hydroxy-phenylbenzotriazole | 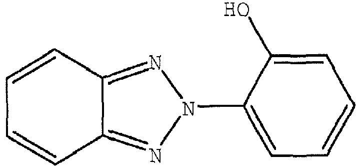 |
| 2-(2-hydroxy-5-methylphenylbenzotriazole | 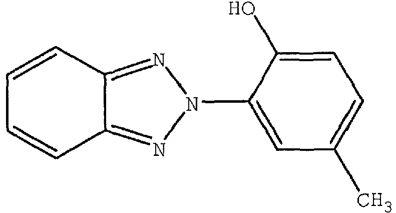 |
| 1H-Benzotriazole-1-methanol | 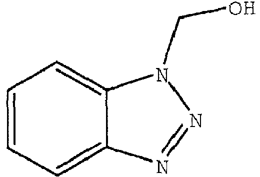 |
| 5-hydroxy-benzimidazole | 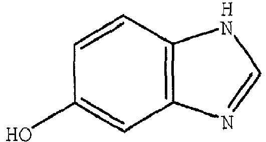 |
| 4(5)-(hydroxymethyl)imidazole | 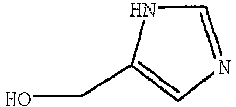 |
| 1-(2-hydroxyethyl)imidazole | 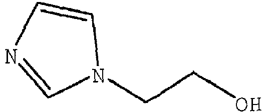 |
| 4-(imidazol-1-yl)phenol | 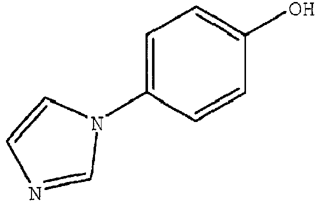 |
| 3-hydroxy-1H-pyrazole | 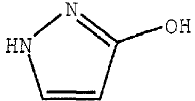 |
| 5-hydroxy-1H-pyrazole | 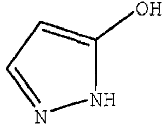 |

In one embodiment, the second functional group is a silane or alkoxy silane. The silane or alkoxysilane can have the following structure (XI): 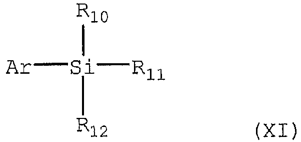 wherein
Ar represents a moiety comprising an aromatic heterocyclic compound comprising nitrogen; and
R₁₀, R₁₁, and R₁₂ are independently selected from among hydrogen, alkyl groups having between one and three carbons, alkoxy groups having between one and three carbons, and alkylcarboxyl groups having between one and three carbons. The silane or alkoxy silane may be bonded directly to the aromatic heterocyclic compound or may be bonded through a linkage, which may be a lower alkyl, having from one to four carbons, such as methylene, ethylene, or propylene, butylene, or an aryl, such as phenyl or benzyl, with alkyl linkage groups being preferred. Preferred silanes/alkoxy silanes include propyltriethoxysilane, propyltrimethoxysilane, propylmethyldiethoxysilane, and propylmethyldimethoxysilane.

Preferred aromatic heterocycles for bonding to silanes and alkoxy silanes include benzotriazole and imidazole. Exemplary compounds comprising alcohols bonded to aromatic heterocycles comprising nitrogen include the compounds in the following Table VIII:

**Table VIII. Multi-functional Compounds Comprising Silanes**

| Name | Structure |
|---|---|
| 1-(Trimethylsilyl)-1H-benzotriazole | 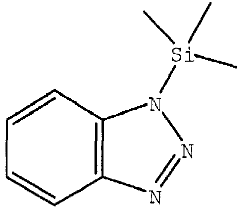 |
| 1-[(trimethylsilyl)methyl] benzotriazole | 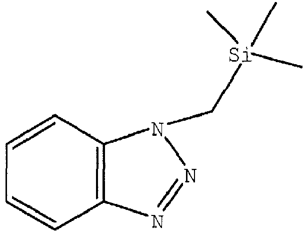 |
| 1-(trimethylsilyl) imidazole | 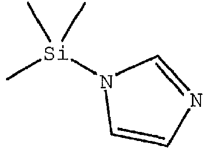 |
| 1-(tert-butyldimethylsilyl) imidazole | 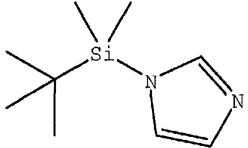 |

The multi-functional compound may added to an adhesion promotion composition in a concentration between about 50 g/L and about 0.05g/L, preferably between about 10 g/L and about 1 g/L.

The above-described multi-functional compounds are typically sparingly soluble in water. Accordingly, the adhesion promotion composition of the present invention may comprise a supplemental alcohol solvent to enhance the solubility of the multi-functional molecules. Exemplary alcohols for use in the adhesion promotion compositions of the present invention include diols, triols, and higher polyols. Suitable alcohols include ethanol, n-propanol, isopropanol, 1-butanol, 2-butanol, tert-butanol, iso-butanol, 1-pentanol, 2-pentanol, other pentanols, 1-hexanol, other hexanols, heptanols, 1-octanol, 2-octanol, and other octanols, 1-decanol and other decanols, phenol, benzyl alcohol, ethylene glycol, propane-1,2-diol, butane-1,2-diol, butane-1,3-diol, butane-1,4-diol, propane-1,3-diol, hexane-1,4-diol hexane-1,5-diol, hexane-1,6-diol, 2-methoxyethanol, 2-ethoxyethanol, 2-propoxyethanol, 2-butoxyethanol, 1-methoxy-2-propanol, 3-methoxy-1-propanol, 3-ethoxy-1-propanol, etc. Then there are unsaturated diols, such as butene-diol, hexene-diol, and acetylenics such as butyne diol. A suitable triol is glycerol. Additional alcohols include triethylene glycol, diethylene glycol, diethylene glycol methyl ether, triethylene glycol monomethyl ether, triethylene glycol dimethyl ether, propylene glycol, dipropylene glycol, allyl alcohol, furfuryl alcohol, and tetrahydrofurfuryl alcohol.

The alcohol may be present in the composition at an initial concentration of at least about 10 mL/L. Typically, the concentration of the alcohol is at least about 100 mL/L, more typically at least about 150 mL/L. The alcohol may be present in the composition at a concentration up to its solubility limit in water. It is within the scope of the invention to employ solvent systems comprised entirely of alcohol. In aqueous solvent systems wherein the alcohol is a supplementary solvent, the concentration of the alcohol may be as much as about 750 mL/L, about 650 mL, or less, such as about 600 mL/L or about 500 mL/L, more typically less than about 200 mL/L. Accordingly, the alcohol concentration may be between about 10 mL/L and about 750 mL/L, typically between about 150 mL/L and about 500 mL/L.

In addition to the above-described components, the adhesion promotion composition may optionally comprise an oxidizing agent and an inorganic acid. Additionally, the adhesion promotion composition may comprise surfactants to further enhance the solubility of the multi-functional molecules and to aid in cleaning the metal surface. The adhesion promotion composition of the present invention may also comprise a source of transition metal ion and a source of halide.

In one embodiment, the oxidizing agent is hydrogen peroxide. Hydrogen peroxide may be present in the adhesion promotion composition at a concentration of at least about 1 wt. %. The concentration of hydrogen peroxide is typically no greater than about 20 wt. %, and in certain preferred embodiments, it is no greater than about 10 wt. %. In one embodiment, the concentration of hydrogen peroxide is between about 0.5% by weight of the adhesion promotion composition and about 4% by weight. It has been found that when the concentration of hydrogen peroxide in the adhesion promotion composition is too high the structure of the roughened surface of the conducting layer forms a somewhat dendritic structure which is more fragile than the desired roughening effect, so that it forms a weaker bond than when lower concentrations of hydrogen peroxide are used. Moreover, a high hydrogen peroxide concentration may cause the OMCC to become hazy due to over-etching. All concentrations are normalized such that they refer to concentrations of each element as if used in 100% concentrations. For example, in one embodiment the H₂O₂ solution added to the composition is 35% concentrated H₂O₂, rather than a 100% concentrated H₂O₂. However, the concentrations in the final composition are based on wt. % from 100% H₂O₂, not wt. % of 35% H₂O₂ in the final composition.

The adhesion promotion composition may comprise one or more inorganic acids for the main purpose of enhancing the solubility of copper and maintaining other components of the composition in solution. A variety of acids, such as mineral acids including phosphoric acid, nitric acid, sulfuric acid, and mixtures thereof are workable. In a preferred embodiment, both HNO₃ and H₂SO₄ are employed. It has been discovered that in addition to enhancing the solubility of the Cu, H₂SO₄ helps to moderate the etch rate, and therefore help prevent over-etching of the substrate in isolated areas. The HNO₃ increases the etch rate, increases the solubility of Cu, helps prevent premature sludge formation, and works with H₂O₂, H₂SO₄, and the multi-functional compound to darken the coating. The overall acid concentration in the composition is generally at least 1 wt. %, preferably at least 8 wt. %, and in certain preferred embodiments at least 14 wt. % of the composition. The etch rate is slowed excessively if the acid concentration is too high, with the exception of nitric acid, and can yield an organometallic conversion coating which is non-uniform and too light in color. For this reason, the acidity level in previous compositions had been typically selected to be about 20 wt. %. However, in the present invention it is possible to push the acidity level up to about 25 wt. % and above, because with the other additives described herein, the coating is not lightened as would otherwise be expected with an acid level elevated to about 25 wt. %. The overall acid level is typically maintained below about 50 wt. %. In one preferred embodiment, therefore, there is between about 22 wt. % and about 28 wt. % acid, including about 20 wt. % H₂SO₄ (50% grade) and about 5 wt. % HNO₃ (95% grade). In one preferred embodiment, the inorganic acid constitutes at least about 30 wt. % of the composition. Another preferred embodiment employs 28 wt. % H₂SO₄ (50% grade) and 5 wt. % HNO₃ (95% grade). HNO₃ is employed in these preferred embodiments because it has been discovered that it has a unique ability to solubilize the inhibitor-Cu complex better than other mineral acids. The high inorganic acid concentrations yield solutions have strongly acidic pH, such as below about 2.0, preferably below about 1.0. While these percentages above are percentages of the acids in the final composition and are based on use of 100% concentrated acid, as discussed above, the preferred forms of the acids actually added are 50% concentrated H₂SO₄ and about 95% concentrated HNO₃.

One embodiment of the invention employs a sulfonated anionic surfactant. It has been discovered that in addition to surface wetting, this surfactant helps to stabilize the H₂O₂. The most particularly preferred of such surfactants is dodecylbenzene sulfonic acid (DDBSA) or the sodium salt of dodecylbenzene sulfonic acid. DDBSA is commercially available as the acid or the sodium salt from, for example, Ashland Distribution Company (Santa Ana, CA) or from Pilot Chemical Company of (Santa Fe Springs, CA) under the trade designation Calsoft LAS 99. Sodium dodecylbenzene sulfonate is also commercially available from Witco Corporation, Organic Division, (New York, NY) under the trade designation Witconate 1850. Additional surfactants include isopropyl amine branched alkyl benzene sulfonate available from Stepan Company (Northfield, Il) under the trade designation Polystep A-11; and TEA dodecylbenzene sulfonate available from Norman, Fox & Company (Vernon, CA) under the trade designation Norfox T-60. This surfactant is used in a quantity sufficient to achieve surface wetting and H₂O₂ stabilization, which quantity can vary depending on the overall composition of the adhesion promoter. One currently preferred embodiment includes at least about 0.0001% of sulfonated anionic surfactant. As a general proposition, the sulfonated anionic surfactant concentration is at least about 0.005%, preferably at least about 0,1%; and is less than about 10%, preferably less than about 5%, more preferably less than about 2%. One specific example employs 0.002% of surfactant, particularly DDBSA.

A currently preferred embodiment of the invention also incorporates a sulfated anionic surfactant. One preferred example of this compound is sodium 2-ethylhexyl sulfate, also known as 2-ethylhexanol sulfate sodium salt, having the formula C₄H₉CH(C₂H₅)CH₂SO₄⁻ Na⁺. This is available from Niacet Corporation (Niagara Falls, NY) under the trade designation Niaproof 08, which contains 38.5 to 40.5% sodium 2-ethylhexyl sulfate and the balance water. Alternatives include sodium tetradecyl sulfate available from Niacet under the trade designation Niaproof 4, sodium lauryl sulfate available from Stepan Company (Northfield, Il) under the trade designation Polystep B-5, and sodium n-decyl sulfate available from Henkel Corporation/Emery Group, Cospha/CD of (Ambler, PA) under the trade designation Sulfotex 110. The addition of a sulfated anionic surfactant compound surprisingly permits the acidity level to be raised, without the expected detrimental effect of lightening the coating. Because the acidity level can be raised in this manner, copper loading is increased. It also helps darken the coating. This compound is present in this embodiment in a concentration sufficient to increase copper loading without substantial lightening of the coating. The typical concentration is at least about 0,001%, and preferably at least about 0.1%. The concentration of sulfated anionic surfactant is no greater than about 10%, and preferably no greater than about 5%. One preferred range is between about 0.05 and 2%. In one preferred embodiment the sulfated anionic surfactant concentration is about 0.5%. In another it is 0.15%.

In a currently preferred embodiment, the composition also includes one or more ethoxylated phenol derivatives as a nonionic surfactant. This surfactant has been discovered to provide the unexpected additional benefit of improving peel strength. In one preferred embodiment, this surfactant is one or more ethoxylated nonylphenols, such as polyoxyethylene nonylphenol. Polyoxyethylene nonylphenol is available from Dow Chemical Company (Midland, MI) under the trade designation Tergitol NP9. Alternatives include an ethoxylated nonylphenol available from Dow Chemical Company under the trade designation Tergitol NP8, nonylphenoxypolyethoxyethanol available from Union Carbide Corporation (Danbury, CT) under the trade designation Triton N, and ethoxylated nonylphenol (or nonoxynol-2) available from Rhone-Poulenc, Surfactant & Specialty Division of New Jersey under the trade designation Igepal CO-210.

The concentration of this surfactant is selected to be sufficient to improve peel strength. One currently preferred embodiment includes at least about 0.0001% of an ethoxylated phenol derivative. As a general proposition, the concentration is at least about 0.01%, preferably at least about 0.2%; and is less than about 10%, preferably less than about 5%. One preferred range is between about 0.0001% and about 2%, such as between about 0.01% and about 1%, such as from about 0.02% to about 1%.

In another currently preferred embodiment, the composition comprises one or more quaternary amine surfactants. In one preferred embodiment, this surfactant is polyethoxylated quaternary amine. Exemplary such surfactants include the TOMAH quats including: TOMAH Q-14-2 (a 74% active isodecyloxypropyl bis-(2-hydroxyethyl) methyl ammonium chloride), TOMAH Q-17-2 (a 74% active isotridecyloxypropyl bis-(2-hydroxyethyl) methyl ammonium chloride), TOMAH Q-17-5 (a 74% active isotridecyloxypropyl poly(5)oxyethylene methyl ammonium chloride), TOMAH Q-18-2 (a 50% active octadecyl bis-(2-hydroxyethyl) methyl ammonium chloride), TOMAH Q-S (50% or 80% active mono soya methyl ammonium chloride). TOMAH Q-DT (50% active tallow diamine diquaternary), TOMAH Q-C-15 (a 100% active cocopoly(15)oxyethylene methyl ammonium chloride), and TOMAH Q-ST-50 (a 50% active trimethyl stearyl ammonium chloride). In a preferred embodiment, the surfactant is TOMAH Q-14-2 (a 74% active isodecyloxypropyl bis-(2-hydroxyethyl) methyl ammonium chloride) added to the composition in a concentration between about 0.05% and about 5%, such as between about 0.1% and about 2%, such as about 1%.

The composition further includes a source of halide ions, preferably a source of chloride ions. The source may be NaCl or HCl, and provides a chloride ion concentration in the range of about 10 to 100 ppm. The most preferred range for one embodiment is between about 60 and 65 ppm. Preferred ranges are different for other embodiments depending on the overall composition and application. This increased Cl⁻ level in comparison to previous formulations helps to increase the ratio of cuprous copper to cupric copper, which has been discovered to increase peel strength and lengthen the total time to delaminate. The Cl⁻ level tapers off and then stabilizes during use of the composition. As such, an initial Cl⁻ ion concentration of between about 20 ppm and about 100 ppm is preferred in one embodiment in order to achieve a Cl⁻ ion content in service of on the order of about 20 to 80 ppm.

The composition may additionally comprise transition metal ions, such as Zn²⁺ and Ni²⁺. It is believed that transition metal ions enhance thermal resistance of the organometallic conversion coating, Exemplary sources of Zn²⁺ and Ni^{z+} include zinc iodide and nickel iodide, but other water soluble sources may be used as well, such as zinc acetate and nickel acetate. In addition to providing the transition metals, these sources provide halide ion. The source of transition metal ion may be added to the composition to provide between about 10 g/L and about 0.1 g/L transition metal ion.

The adhesion promotion composition is manufactured by mixing the components in an aqueous solution, preferably using deionized water. In a preferred embodiment, the solution further comprises an alcohol to enhance the solubility of the organic components. In accordance with standard safe practice, hydrogen peroxide is added to the composition in a diluted form.

The copper surface is contacted with the adhesion promotion composition generally without any pre-treatment. The copper surface may have previously been provided with a tarnish-inhibiting coating, e.g., by incorporating the tarnish inhibitor into a resist stripping composition used in an immediately preceding step of etch resist stripping. Tarnish inhibitors used in such strippers are, for example, a triazole or other coating. If so, it may be desirable to pre-clean the copper surface before contact with the composition. Pre-cleaning solutions include acidic pre-cleaners such as PC 7077 (available from Enthone Inc. of West Haven, Connecticut), prepared and used according to the manufacturer's instructions. For example, in one embodiment, the copper surface may be pre-cleaned using a commercially available acidic pre-cleaner at a temperature between about 30°C and about 50°, such as between about 30°C and about 40°C for a duration between about 30 seconds and about 3 minutes, such as between about 45 seconds and about 2 minutes. Cleaning with the acidic pre-cleaner is preferably followed by a rinse with distilled water.

Acidic pre-cleaning is preferably followed by alkaline cleaning, such as PC 7086 or PC 7096 (available from Enthone Inc. of West Haven, Connecticut), prepared and used according to the manufacturer's instructions. For example, in one embodiment, the copper surface may be cleaned using a commercially available alkaline pre-cleaner at a temperature between about 40°C and about 60°, such as between about 45°C and about 54°C for a duration between about 20 seconds and about 2 minutes, such as between about 30 seconds and about 1 minute. Cleaning with the alkaline pre-cleaner is preferably followed by a rinse with distilled water.

Preferably, prior to contact with the adhesion promotion composition, the copper surface will be substantially dry or have only minimal wetness. Apart from such a cleaning step, it is generally unnecessary to carry out any pre-treating steps. In a preferred embodiment of the invention, the adhesion promotion step follows immediately after an etch resist stripping step or there is a single pre-cleaning step between the etch resist stripping step and the adhesion promotion step.

Contact with the adhesion promotion composition may be by any conventional means, for example by immersion in a bath of the adhesion promotion composition or by spraying or any other means of contact. Contact may be as part of a continuous process. As is well understood in the art, immersion processes involve simply dipping the substrate into a bath of the composition for the desired period. Spray processes typically involve application using a series of automated squeegee-type mechanisms. The method of application is not critical to the invention. However, the tolerance for copper loading can be greater for spray processes than for dip processes because, for example, there is more bath stagnation with dip processes.

Contact of the copper surface with the adhesion promotion composition is typically at a temperature between about 20°C and about 40°C, though temperatures reasonably outside this range are operable. The contact time is generally no less than 1 second, preferably no less than 5 seconds, and often at least 10 seconds, most preferably at least 30 seconds. The maximum contact time may be up to 10 minutes, although preferably the contact time is no greater than 5 minutes, most preferably no greater than 2 minutes. A contact time of about 1 minute or less than 1 minute is standard. If the contact time of the adhesion promotion composition with the copper surface is too long, there is a risk that the copper surface may be etched away due to dissolution and/or that a deposit other than the micro-porous crystalline deposit that forms the micro-roughened surface will be deposited onto the surface of the conducting material.

After contact of the copper surface with the adhesion promotion composition to form the micro-roughened surface, generally a pre-preg insulating layer may be placed directly adjacent to the copper surface and the pre-preg insulating layer adhered directly to the copper surface in the adhesion step, forming a multi-layer PCB. Generally, in the adhesion step, heat and pressure are applied to initiate the adhesion reaction. In the adhesion step, mechanical bonding is due to penetration of the polymeric material of the insulating layer into the micro-roughened surface provided in the adhesion promotion step. According to the method of the present invention, the second functional group of the multi-functional compound may also chemically bond to the organic material and/or glass fiber present in the pre-preg insulation layer, providing enhanced adhesive strength. Although it may be desirable to follow the adhesion promotion step with a specially formulated rinse step, it is often adequate to rinse just with water.

A pre-preg insulating layer is applied directly to the micro-roughened surface, i.e., preferably without any intermediate metal deposition onto the micro-roughened surface or the like, although optionally with a post-treatment cupric oxide removal or reduction operation to further enhance the bond strength as disclosed in U.S. Pat. No. 6,294,220. Pressure is applied by placing the layers that are to form the multi-layer laminate of the PCB in a press. Where pressure is applied it is generally from 100 to 400 psi, preferably from 150 to 300 psi. The temperature of this adhesion step will generally be at least about 100°C, preferably between about 120°C and about 200°C. The adhesion step is generally carried out for any period from 5 minutes to 3 hours, most usually from 20 minutes to 1 hour, but is for sufficient time and pressure and at a sufficiently high temperature to ensure good adhesion between the first and second layers. During this adhesion step, the polymeric material of the insulating layers, generally an epoxy resin, tends to flow ensuring that the conductive pattern in the metal is substantially sealed between insulating layers, so subsequent penetration of water and air is avoided. Several layers may be placed together in the adhesion step to effect lamination of several layers in a single step to form the MLB.

Though the exemplary arrangement discussed at length herein is a pre-preg insulating layer adhered to a copper surface, the invention also includes improving adhesion of other dielectric materials, whether permanent or temporary, to copper. For example, the invention improves adhesion between copper and a solder mask that is dielectric. It similarly improves copper adhesion with inks, polymeric photo-resists, and dry films. It also has application in connection with photoimageable dielectrics or other dielectrics used in the context of high density interconnect and sequential build up technologies.

In one form the invention is a ready-to-use adhesion promotion composition that can be used directly for immersion or other exposure of the substrate. In another form the invention is a concentrate that is to be diluted to form the composition for immersion or other exposure.

The following examples further illustrate the practice of the present invention.

### EXAMPLES

### Example 1. Adhesion promotion composition

An adhesion promotion composition comprising a multi-functional azole was prepared having the following components:
6-benzylamino-purine (1.0 g)
Ethylene glycol butyl ether (200 mL)
ZnI₂ (1.0g)
Water (to 1 L).

The composition was prepared according to the following protocol:
1) 6-benzylamino-purine (1.0 g) dissolved in ethylene glycol butyl ether (200 mL).
2) Water (500 mL) added.
3) Homogenized solution.
4) Zinc iodide (1.0 g) dissolved in solution.
5) Water added to solution volume of 1.0 liter.

### Example 2. Adhesion promotion composition

An adhesion promotion composition comprising a multi-functional azole was prepared having the following components:
6-benzylamino-purine (1.0 g)
Ethylene glycol butyl ether (200 mL)
NiI₂ (1.0 g)
Water (to 1 L).

The composition was prepared according to the protocol described in Example 1, except that NiI₂ was added instead of ZnI₂.

### Example 3. Treatment of Pre-treated Copper Samples with Adhesion promotion composition

Two copper test coupons were pre-treated with acid cleaning (PC1010) and microetching (ME 1020) compositions available from Enthone Inc. (West Haven, CT) The copper test coupons then treated with the adhesion promotion compositions of Examples 1 and 2 by dipping one coupon in each composition for 1 minute at room temperature. This treatment forms a film comprising the multi-functional compounds of Examples 1 and 2 over the surface of the copper test coupons.

### Example 4. Wetting balance tests

After the test coupons were treated with the adhesion promotion compositions according to the method of Example 3, the resistance of the adhesion promotion films on the copper coupons to acid and flux was tested by applying solder and flux and passing the coupons through a reflow process. Pb-free solder was applied to the copper coupons.

The flux applied was EF8000 flux available from AlphaMetal Inc. (Jersey City, NJ). The Pb-free solder was reflowed over the copper test coupons at a peak reflow temperature of 262°C.

Copper discoloration was minor after passing 1x lead-free reflow. The coating applied from the composition of Example 1 was thinner than the coating applied from the composition of Example 2, but both coatings were on the order of about 0.1 µm.

The reflowed copper samples having adhesion promotion compositions of Examples 1 and 2 applied thereon were subjected to wetting balance tests.

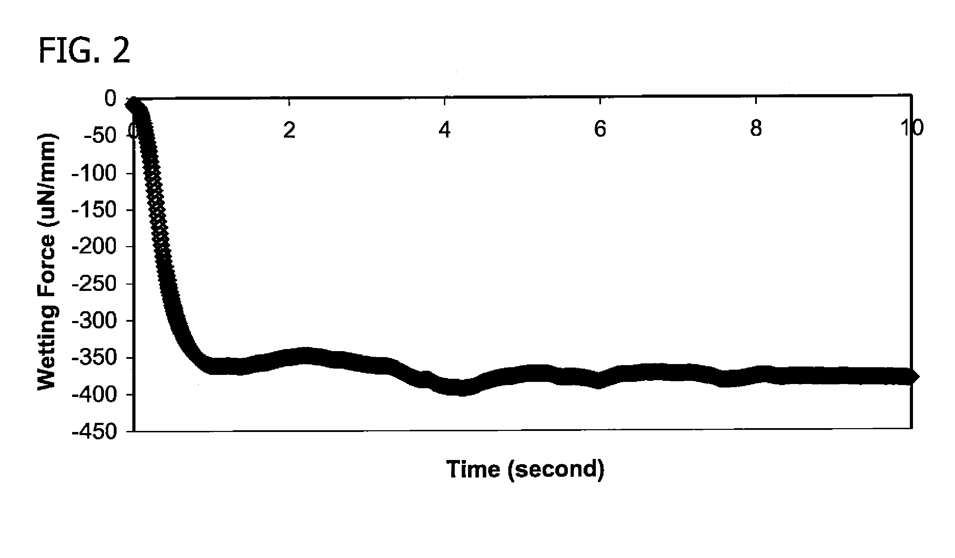

FIGs. 1 and 2 are graphs showing the results of the wetting balance tests. Due to acid resistance, the coating from the composition of Example 2, FIG. 2, showed a dewetting curve, which means that the organometallic coating was not stripped by the flux and had good acid resistance.

### Example 5. X-Ray Photoelectron Spectroscopy on Coated Copper Samples.

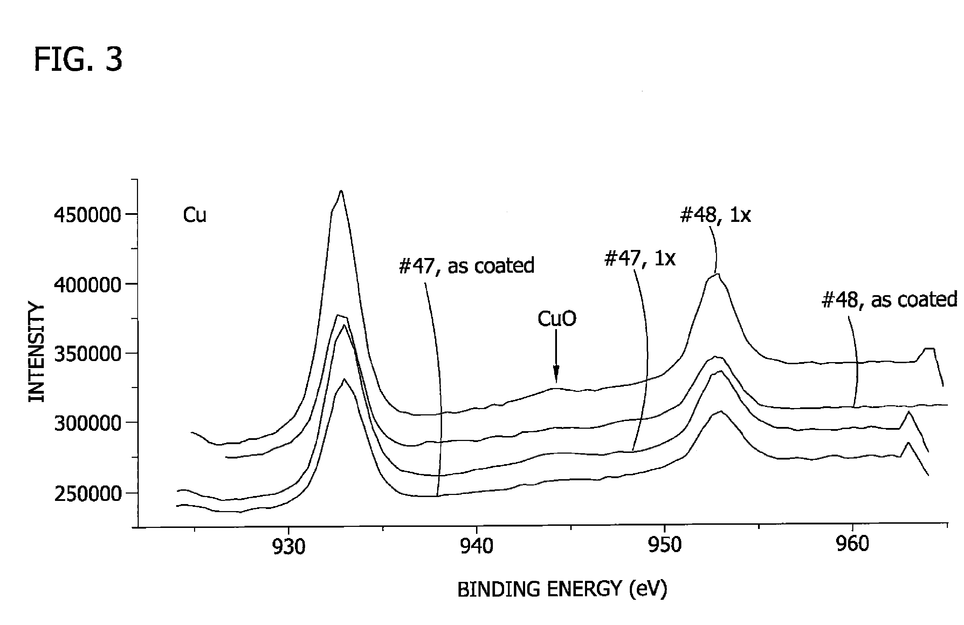

The extent of copper oxidation on the copper coupons treated according to the method of Example 4 before and after reflow was determined by X-ray photoelectron spectroscopy (XPS). FIG. 3 shows XPS spectra of the region from 920 to 965 eV which are useful for determining the oxidation state of copper on the surface of the treated coupons. The slight CuO peak indicates that there is traceable CuO formed after one lead-free reflow (peak temperature is 262°C), which is from the oxidation of copper during reflow processing. In a non-treated coupon, the extent of oxidation would be much greater and the CuO peak would be very high.

Table III is a chart of the quantitative results of XPS analysis of the coating applied from the compositions of Examples 1 and 2, before and after reflow. The chart shows the atomic % of each elements present in the coating. The atomic % of N is not reduced much after reflow. Accordingly, it is believed that amino present in the multi-functional azole molecule after reflow is available for chemical bonding to organic material in the pre-preg insulating layer.

**Table III. Atomic Composition of Coatings**

| | C | Cu | I | N | O | Ni | Zn |
|---|---|---|---|---|---|---|---|
| Example 1 (Pre-reflow) | 65.3 | 5.7 | 1.5 | 20.0 | 6.0 | | 1.5 |
| Example 1 (Post-reflow) | 61.2 | 8.3 | 1.5 | 17.8 | 9.5 | | 1.7 |
| Example 2 (Pre-reflow) | 62.4 | 6.6 | 2.9 | 21.5 | 6.3 | 0.3 | |
| Example 2 (Post-reflow) | 56.5 | 11.6 | 4.0 | 18.5 | 9.1 | 0.3 | |

### Example 6. Adhesion promotion composition

The following adhesion promoting composition was prepared:
TOMAH solution (10 mL, TOMAH Q-14-2, available from TOMAH Products, Inc., Milton, WI)
NaCl solution (5 mL)
H₂SO₄ (96% solution, 105.5 g)
Mixture of benzotriazole-4-carboxylic acid and benzotriazole-5-carboxylic acid (3.8 g)
H₂O₂ (35% solution, 150 mL)
Water to approximately 1.15 L.

This composition may be prepared according to the following protocol:
1) Mixture of benzotriazole-4-carboxylic acid and benzotriazole-5-carboxylic acid (3.8 g) dissolved in sulfuric acid (105.5 g).
2) Water (400 mL) added.
3) Homogenized solution.
4) TOMAH solution (10 mL), NaCl solution (5 mL), and hydrogen peroxide (150 mL) added in order.
5) Water added to the total volume is 1.15 liter.

### Example 7. Treatment of Pre-treated Copper Samples with Adhesion promotion composition

A copper panel was processed using the adhesion promoting composition of Example 6 according to the following protocol:
1) Copper panel pre-treated in Microetch PC5760 (from Enthone Inc.) at 25°C for 30 seconds.
2) Rinsed with D.I. water.
3) Copper panel dipped in Alkaline Cleaner PC-7047 (from Enthone Inc.) at 45°C for 40 seconds.
4) Rinsed with D.I. water.
5) Copper panel dipped in the adhesion promotor composition of Example 6 at 32°C for 3 minutes.

After the treatment, the copper coupon was processed through lamination procedure to determine the peel-off strength. The peel-off strength is 0.193 N/mm.

In view of the above, it will be seen that the several objects of the invention are achieved and other advantageous results attained.

When introducing elements of the present invention or the preferred embodiment(s) thereof, the articles "a", "an", "the" and "said" are intended to mean that there are one or more of the elements. The terms "comprising", "including" and "having" are intended to be inclusive and mean that there may be additional elements other than the listed elements.

As various changes could be made in the above without departing from the scope of the invention, it is intended that all matter contained in the above description and shown in the accompanying drawings shall be interpreted as illustrative and not in a limiting sense.
Further embodiments of the invention are disclosed in the following clauses.
1. An adhesion promotion composition for enhancing adhesion between a copper conducting layer and a dielectric material during manufacture of a printed circuit board, the adhesion promotion composition comprising:
   a multi-functional compound comprising a first functional group and a second functional group, wherein (1) the first functional group is selected from the group consisting of an aromatic heterocyclic compound comprising nitrogen and an aliphatic amine, and (2) the second functional group is selected from the group consisting of vinyl ether, amide, thiamide, amine, carboxylic acid, ester, alcohol, silane, alkoxy silane, and combinations thereof;
   a surfactant; and
   an acid.
2. The adhesion promotion composition of clause 1 wherein the aromatic heterocyclic compound comprising nitrogen is an azole.
3. The adhesion promotion composition of clause 2 wherein the azole comprises at least one nitrogen atom bonded to an acidic hydrogen atom.
4. The adhesion promotion composition of clause 1 wherein the second functional group is bonded to a carbon atom of the aromatic heterocyclic compound comprising nitrogen.
5. The adhesion promotion composition of clause 1 wherein the second functional group is bonded to a nitrogen atom of the aromatic heterocyclic compound comprising nitrogen and the aromatic heterocyclic compound comprising nitrogen comprising at least one other nitrogen atom bonded to an acidic hydrogen atom.
6. The adhesion promotion composition of clause 1 wherein the pKa of the aromatic heterocyclic compound comprising nitrogen is between about 5 and about 13, about 5 and about 11, about 6 and about 10, about 7.5 and about 9.0, or about 8.0 and about 8.8.
7. The adhesion promotion composition of clause 1 wherein the aromatic heterocyclic compound comprising nitrogen interacts with copper(I) ions on the surface of the copper conducting layer and copper(II) ions in solution in a manner sufficient to form a film comprising copper(I)-based organometallics on the surface of the copper conducting layer, the film thereby increasing the ratio of copper(I) ions to copper(II) ions on the surface of the copper conducting layer.
8. The adhesion promotion composition of clause 1 wherein the multi-functional compound has structure (Ia) or structure (Ib): 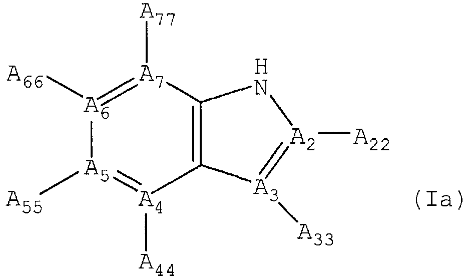 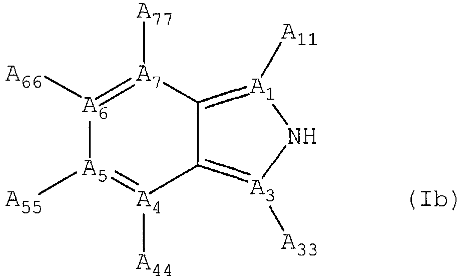 wherein:
   A₁, A₂, A₃, A₄, A₅, A₆, and A₇ are carbon atoms or nitrogen atoms and the sum of nitrogen atoms from A₁, A₂, A₃, A₄, A₅, A₆, and A₇ is 0, 1, 2, or 3;
   A₁₁, A₂₂, A₃₃, A₄₄, A₅₅, A₆₆, and A₇₇ are selected from the group consisting of electron pair, hydrogen, substituted or unsubstituted alkyl, substituted or unsubstituted aryl, substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane; and
   at least one of A₁₁, A₂₂, A₃₃, A₄₄, and A₅₅ is selected from the group consisting of substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane.
9. The adhesion promotion composition of clause 8 wherein the structure of the multi-functional compound is selected from the group consisting of structure (II), structure (III), and structure (IV): 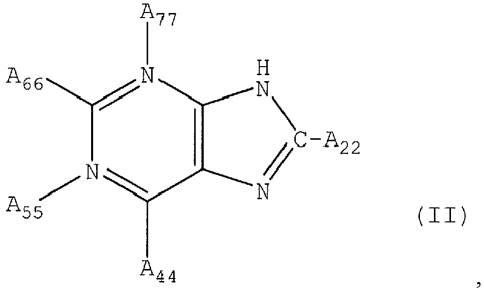 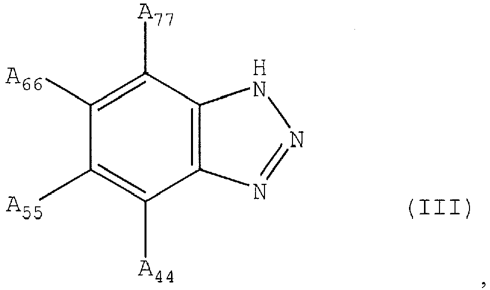 or 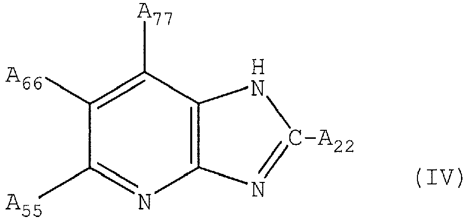 wherein A₂₂, A₄₄, A₅₅, A₆₆, and A₇₇ are as defined in connection with structures (Ia) and (Ib).
10. The adhesion promotion composition of clause 1 wherein the multi-functional compound has structure (V): 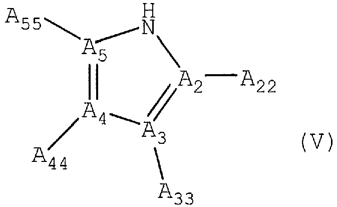 wherein:
   A₂, A₃, A₄ and A₅ are carbon atoms or nitrogen atoms and the sum of nitrogen atoms from A₂, A₃, A₄ and A₅ is 0, 1 or 2;
   A₂₂, A₃₃, A₄₄, and A₅₅ are selected from the group consisting of hydrogen, substituted or unsubstituted alkyl, substituted or unsubstituted aryl, substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane; and
   at least one of A₂₂, A₃₃, A₄₄, and A₅₅ is selected from the group consisting of substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane.
11. The adhesion promotion composition of any one of clauses 1 through 10 wherein the second functional group is the vinyl ether.
12. The adhesion promotion composition of clause 11 wherein the first functional group is selected from the group consisting of benzimidazole, indazole, imidazole, and triazole.
13. The adhesion promotion composition of clause 11 wherein the multi-functional compound is selected from the group consisting of 2-(vinyloxy)-1H-benzimidazole, 2-(vinyloxymethyl)-1H-benzimidazole, 3-(vinyloxy)-2H-indazole, 2-(vinyloxy)-1H-imidazole, 2-(vinyloxymethyl)-1H-imidazole, and 3-(vinyloxy)-1H-1,2,4-triazole.
14. The adhesion promotion composition of any one of clauses 1 through 10 wherein the second functional group is the amine.
15. The adhesion promotion composition of clause 14 wherein the first functional group is selected from the group consisting of purine, benzotriazole, benzimidazole, imidazole, and pyrazole
16. The adhesion promotion composition of clause 14 wherein the multi-functional compound is selected from the group consisting of 6-phenylamino-purine, 6-benzylamino-purine, 6-methylamine-purine, 6-dimethyl-purine, 9H-purine-2,6-diamine, α-methyl-N-phenyl-1H-benzotriazole-1-methanamine, 2-(2-aminoethyl)benzimidazole, 2-(2-aminophenyl)-1H-benzimidazole, histamine, 1-methylhistamine, 3-methylhistamine, 1-(3-aminopropyl)imidazole, and 3-amino-pyrazole.
17. The adhesion promotion composition of any one of clauses 1 through 10 wherein the second functional group is the amide or the thiamide.
18. The adhesion promotion composition of clause 17 wherein the first functional group is selected from the group consisting of purine and benzotriazole.
19. The adhesion promotion composition of clause 17 wherein the multi-functional compound is selected from the group consisting of 5-acetamide-benzotriazole, 8-para-methylbenzamide-purine, Benzotriazole-1-carboxamide, N-(2-propenyl)-1H-benzotriazole-1-carbothiamide, and N-phenyl-1H-benzotriazole-1-carboxamide.
20. The adhesion promotion composition of any one of clauses 1 through 10 wherein the second functional group is the carboxylic acid.
21. The adhesion promotion composition of clause 20 wherein the first functional group is selected from the group consisting ofbenzotriazole, imidazole, and pyrazole.
22. The adhesion promotion composition of clause 20 wherein the multi-functional compound is selected from the group consisting of benzotriazole-4-carboxylic acid, benzotriazole-5-carboxylic acid, imidazole-4-acetic acid, 1H-pyrazole-4-carboxylic acid, and 1H-pyrazole-5-carboxylic acid.
23. The adhesion promotion composition of any one of clauses 1 through 10 wherein the second functional group is the ester.
24. The adhesion promotion composition of clause 23 wherein the first functional group is selected from the group consisting of benzotriazole and imidazole.
25. The adhesion promotion composition of clause 23 wherein the multi-functional compound is selected from the group consisting of methyl 1H-benzotriazole-1-carboxylate, phenyl 1H-1,2,3-benzotriazole-5-carboxylate, 1-(benzyloxycarbonyl) Benzotriazole, and 1H-imidazole-4,5-dicarboxylic acid dimethyl ester.
26. The adhesion promotion composition of any one of clauses 1 through 10 wherein the second functional group is the alcohol.
27. The adhesion promotion composition of clause 26 wherein the first functional group is selected from the group consisting of benzotriazole, benzimidazole, imidazole, and pyrazole.
28. The adhesion promotion composition of clause 26 wherein the multi-functional compound is selected from the group consisting of 4-hydroxy-1H-benzotriazole, 2-(2-hydroxyphenylbenzotriazole, 2-(2-hydroxy-5-methylphenylbenzotriazole, 1H-Benzotriazole-1-methanol, 5-hydroxy-benzimidazole, 4(5)-(hydroxymethyl)imidazole, 1-(2-hydroxyethyl)imidazole, 4-(imidazol-1-yl)phenol, 3-hydroxy-1H-pyrazole, and 5-hydroxy-1H-pyrazole.
29. The adhesion promotion composition of any one of clauses 1 through 10 wherein the second functional group is the silane or the alkoxy silane.
30. The adhesion promotion composition of clause 29 wherein the first functional group is selected from the group consisting of benzotriazole and imidazole.
31. The adhesion promotion composition of clause 29 wherein the multi-functional compound is selected from the group consisting of 1-(trimethylsilyl)-1H-benzotriazole, 1-[(trimethylsilyl)methyl] benzotriazole, 1-(trimethylsilyl) imidazole, and 1-(tert-butyldimethylsilyl) imidazole.
32. A method for enhancing adhesion between a copper conducting layer and a dielectric material during manufacture of a printed circuit board, the process comprising:
   exposing the copper conducting layer to an adhesion promotion composition of any one of clauses 1 through 31.
33. A method for enhancing adhesion between a copper conducting layer and a dielectric material during manufacture of a printed circuit board, the process comprising:
   exposing the copper conducting layer to an adhesion promotion composition comprising a multi-functional compound comprising a first functional group and a second functional group, wherein (1) the first functional group is selected from the group consisting of an aromatic heterocyclic compound comprising nitrogen and an aliphatic amine, and (2) the second functional group is selected from the group consisting of vinyl ether, amide, thiamide, amine, carboxylic acid, ester, alcohol, silane, alkoxy silane, and combinations thereof, wherein the first functional group interacts with the surface of the copper conducting layer to form a copper(I) rich organometallic adhesive film over the surface of the copper conductive substrate.
34. The method of clause 33 further comprising the step of applying the dielectric material to the copper conducting material having the copper(I) rich organometallic adhesive film thereon, wherein the second functional group reacts with the dielectric material to form a chemical bond between the multi-functional compound and the dielectric material.
35. The method of clause 33 wherein the aromatic heterocyclic compound comprising nitrogen is an azole.
36. The method of clause 35 wherein the azole comprises at least one nitrogen atom bonded to an acidic hydrogen atom.
37. The method of clause 33 wherein the second functional group is bonded to a carbon atom of the aromatic heterocyclic compound comprising nitrogen.
38. The method of clause 33 wherein the second functional group is bonded to a nitrogen atom of the aromatic heterocyclic compound comprising nitrogen and the aromatic heterocyclic compound comprising nitrogen comprising at least one other nitrogen atom bonded to an acidic hydrogen atom.
39. The method of clause 33 wherein the pKa of the aromatic heterocyclic compound comprising nitrogen is between about 5 and about 13, about 5 and about 11, about 6 and about 10, about 7.5 and about 9.0, or about 8.0 and about 8.8.
40. The method of clause 33 wherein the aromatic heterocyclic compound comprising nitrogen interacts with copper(I) ions on the surface of the copper conducting layer and copper(II) ions in solution in a manner sufficient to form a film comprising copper(I)-based organometallics on the surface of the copper conducting layer, the film thereby increasing the ratio of copper(I) ions to copper(II) ions on the surface of the copper conducting layer.
41. The method of clause 33 wherein the multi-functional compound has structure (Ia) or structure (Ib): 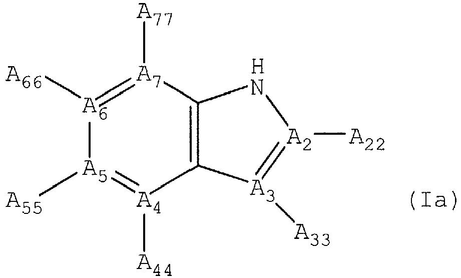 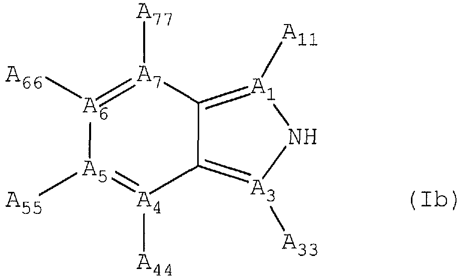 wherein:
   A₁, A₂, A₃, A₄, A₅, A₆, and A₇ are carbon atoms or nitrogen atoms and the sum of nitrogen atoms from A₁, A₂, A₃, A₄, A₅, A₆, and A₇ is 0, 1, 2, or 3;
   A₁₁, A₂₂, A₃₃, A₄₄, A₅₅, A₆₆, and A₇₇ are selected from the group consisting of electron pair, hydrogen, substituted or unsubstituted alkyl, substituted or unsubstituted aryl, substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane; and
   at least one of A₁₁, A₂₂, A₃₃, A₄₄, and A₅₅ is selected from the group consisting of substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane.
42. The method of clause 41 wherein the structure of the multi-functional compound is selected from the group consisting of consisting of structure (II), structure (III), and structure (IV): 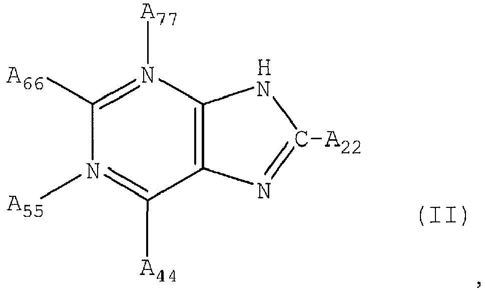 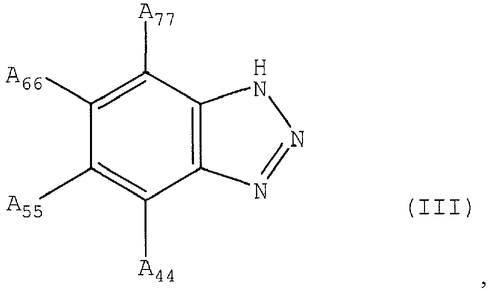 or 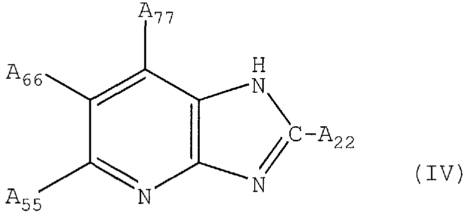 wherein A₂₂, A₄₄, A₅₅, A₆₆, and A₇₇ are as defined in connection with structures (Ia) and (Ib).
43. The method of clause 33 wherein the multi-functional compound has structure (V): 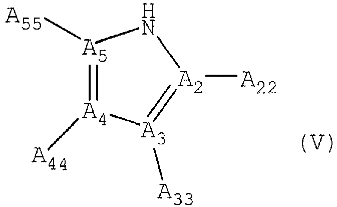 wherein:
   A₂, A₃, A₄ and A₅ are carbon atoms or nitrogen atoms and the sum of nitrogen atoms from A₂, A₃, A₄ and A₅ is 0, 1 or 2;
   A₂₂, A₃₃, A₄₄, and A₅₅ are selected from the group consisting of hydrogen, substituted or unsubstituted alkyl, substituted or unsubstituted aryl, substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane; and
   at least one of A₂₂, A₃₃, A₄₄, and A₅₅ is selected from the group consisting of substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane.
44. The method of any one of clauses 33 through 43 wherein the second functional group is the vinyl ether.
45. The method of clause 44 wherein the first functional group is selected from the group consisting of benzimidazole, indazole, imidazole, and triazole.
46. The method of clause 44 wherein the multi-functional compound is selected from the group consisting of 2-(vinyloxy)-1H-benzimidazole, 2-(vinyloxymethyl)-1H-benzimidazole, 3-(vinyloxy)-2H-indazole, 2-(vinyloxy)-1H-imidazole, 2-(vinyloxymethyl)-1H-imidazole, and 3-(vinyloxy)-1H-1,2,4-triazole.
47. The method of any one of clauses 33 through 43 wherein the second functional group is the amine.
48. The method of clause 47 wherein the first functional group is selected from the group consisting of purine, benzotriazole, benzimidazole, imidazole, and pyrazole
49. The method of clause 47 wherein the multi-functional compound is selected from the group consisting of 6-phenylamino-purine, 6-benzylamino-purine, 6-methylamine-purine, 6-dimethyl-purine, 9H-purine-2,6-diamine, α-methyl-N-phenyl-1H-benzotriazole-1-methanamine, 2-(2-aminoethyl)benzimidazole, 2-(2-aminophenyl)-1H-benzimidazole, histamine, 1-methylhistamine, 3-methylhistamine, 1-(3-aminopropyl)imidazole, and 3-amino-pyrazole.
50. The method of any one of clauses 33 through 43 wherein the second functional group is the amide or the thiamide.
51. The method of clause 50 wherein the first functional group is selected from the group consisting of purine and benzotriazole.
52. The method of clause 50 wherein the multi-functional compound is selected from the group consisting of 5-acetamide-benzotriazole, 8-para-methylbenzamide-purine, Benzotriazole-1-carboxamide, N-(2-propenyl)-1H-benzotriazole-1-carbothiamide, and N-phenyl-1H-benzotriazole-1-carboxamide.
53. The method of any one of clauses 33 through 43 wherein the second functional group is the carboxylic acid.
54. The method of clause 53 wherein the first functional group is selected from the group consisting of benzotriazole, imidazole, and pyrazole.
55. The method of clause 53 wherein the multi-functional compound is selected from the group consisting of benzotriazole-4-carboxylic acid, benzotriazole-5-carboxylic acid, imidazole-4-acetic acid, 1H-pyrazole-4-carboxylic acid, and 1H-pyrazole-5-carboxylic acid.
56. The method of any one of clauses 33 through 43 wherein the second functional group is the ester.
57. The method of clause 56 wherein the first functional group is selected from the group consisting of benzotriazole and imidazole.
58. The method of clause 56 wherein the multi-functional compound is selected from the group consisting of methyl 1H-benzotriazole-1-carboxylate, phenyl 1H-1,2,3-benzotriazole-5-carboxylate, 1-(benzyloxycarbonyl) Benzotriazole, and 1H-imidazole-4,5-dicarboxylic acid dimethyl ester.
59. The method of any one of clauses 33 through 43 wherein the second functional group is the alcohol.
60. The method of clause 59 wherein the first functional group is selected from the group consisting of benzotriazole, benzimidazole, imidazole, and pyrazole.
61. The method of clause 59 wherein the multi-functional compound is selected from the group consisting of 4-hydroxy-1H-benzotriazole, 2-(2-hydroxy-phenylbenzotriazole, 2-(2-hydroxy-5-methylphenylbenzotriazole, 1H-Benzotriazole-1-methanol, 5-hydroxy-benzimidazole, 4(5)-(hydroxymethyl)imidazole, 1-(2-hydroxyethyl)imidazole, 4-(imidazol-1-yl)phenol, 3-hydroxy-1H-pyrazole, and 5-hydroxy-1H-pyrazole.
62. The method of any one of clauses 33 through 43 wherein the second functional group is the silane or the alkoxy silane.
63. The method of clause 62 wherein the first functional group is selected from the group consisting of benzotriazole and imidazole.
64. The method of clause 62 wherein the multi-functional compound is selected from the group consisting of 1-(trimethylsilyl)-1H-benzotriazole, 1-[(trimethylsilyl)methyl] benzotriazole, 1-(trimethylsilyl) imidazole, and 1-(tert-butyldimethylsilyl) imidazole.

## Claims

1. An adhesion promotion composition for enhancing adhesion between a copper conducting layer and a dielectric material during manufacture of a printed circuit board, the adhesion promotion composition comprising:
a multi-functional compound comprising a first functional group and a second functional group, wherein (1) the first functional group is selected from the group consisting of an aromatic heterocyclic compound comprising nitrogen and an aliphatic amine, and (2) the second functional group is selected from the group consisting of vinyl ether, amide, thiamide, amine, carboxylic acid, ester, alcohol, silane, alkoxy silane, and combinations thereof;
a surfactant; and
an acid.

2. The adhesion promotion composition of claim 1 wherein the aromatic heterocyclic compound comprising nitrogen is an azole.

3. The adhesion promotion composition of claim 1 wherein the multi-functional compound has structure (Ia) or structure (Ib): 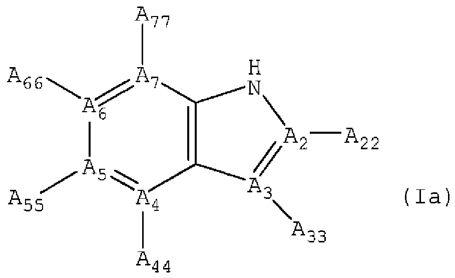 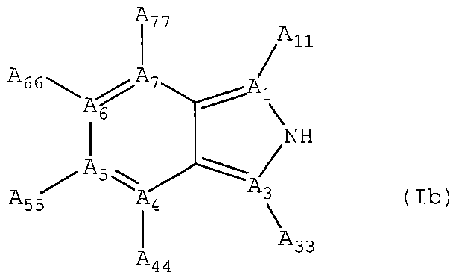 wherein:
A₁, A₂, A₃, A₄, A₅, A₆, and A₇ are carbon atoms or nitrogen atoms and the sum of nitrogen atoms from A₁, A₂, A₃, A₄, A₅, A₆, and A₇ is 0, 1, 2, or 3;
A₁₁, A₂₂, A₃₃, A₄₄, A₅₅, A₆₆, and A₇₇ are selected from the group consisting of electron pair, hydrogen, substituted or unsubstituted alkyl, substituted or unsubstituted aryl, substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane; and
at least one of A₁₁, A₂₂, A₃₃, A₄₄, and A₅₅ is selected from the group consisting of substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane.

4. The adhesion promotion composition of claim 3 wherein the structure of the multi-functional compound is selected from the group consisting of structure (II), structure (III), and structure (IV): 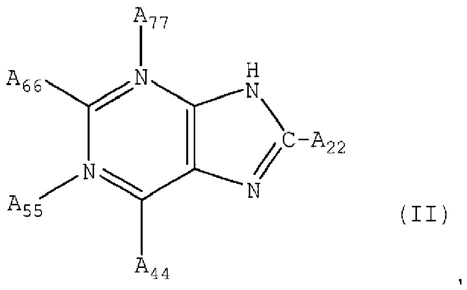 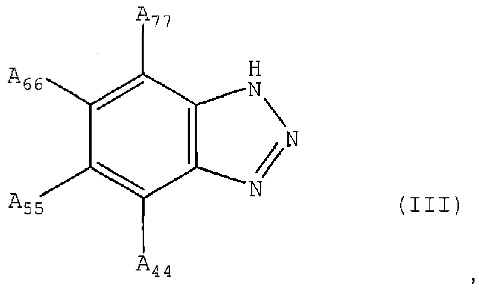 or 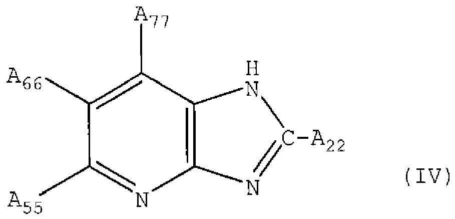 wherein A₂₂, A₄₄, A₅₅, A₆₆, and A₇₇ are as defined in connection with structures (Ia) and (Ib).

5. The adhesion promotion composition of claim 1 wherein the multi-functional compound has structure (V): 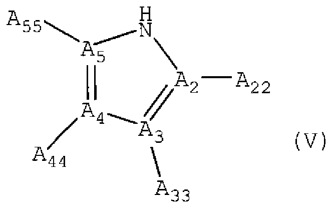 wherein:
A₂, A₃, A₄ and A₅ are carbon atoms or nitrogen atoms and the sum of nitrogen atoms from A₂, A₃, A₄ and A₅ is 0, 1 or 2;
A₂₂, A₃₃, A₄₄, and A₅₅ are selected from the group consisting of hydrogen, substituted or unsubstituted alkyl, substituted or unsubstituted aryl, substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane; and
at least one of A₂₂, A₃₃, A₄₄, and A₅₅ is selected from the group consisting of substituted or unsubstituted vinyl ether, substituted or unsubstituted amide, substituted or unsubstituted amine, substituted or unsubstituted carboxylic acid, substituted or unsubstituted ester, substituted or unsubstituted alcohol, and substituted and unsubsituted silane or alkoxysilane.

6. A method for enhancing adhesion between a copper conducting layer and a dielectric material during manufacture of a printed circuit board, the process comprising:
exposing the copper conducting layer to an adhesion promotion composition according to one of the foregoing claims wherein the first functional group interacts with the surface of the copper conducting layer to form a copper(I) rich organometallic adhesive film over the surface of the copper conductive substrate.

7. The method of claim 6 wherein the aromatic heterocyclic compound comprising nitrogen is an azole.

8. The method of claim 7 wherein the azole comprises at least one nitrogen atom bonded to an acidic hydrogen atom.

9. The method of claim 6 wherein the second functional group is bonded to a carbon atom of the aromatic heterocyclic compound comprising nitrogen.

10. The method of claim 6 wherein the second functional group is bonded to a nitrogen atom of the aromatic heterocyclic compound comprising nitrogen and the aromatic heterocyclic compound comprising nitrogen comprising at least one other nitrogen atom bonded to an acidic hydrogen atom.

11. The method of claim 6 wherein the aromatic heterocyclic compound comprising nitrogen interacts with copper(I) ions on the surface of the copper conducting layer and copper(II) ions in solution in a manner sufficient to form a film comprising copper(I)-based organometallics on the surface of the copper conducting layer, the film thereby increasing the ratio of copper(I) ions to copper(II) ions on the surface of the copper conducting layer.

12. The method of claim 6 wherein the second functional group is the vinyl ether.

13. The method of claim 12 wherein the multi-functional compound is selected from the group consisting of 2-(vinyloxy)-1H-benzimidazole, 2-(vinyloxymethyl)-1H-benzimidazole, 3-(vinyloxy)-2H-indazole, 2-(vinyloxy)-1H-imidazole, 2-(vinyloxymethyl)-1H-imidazole, and 3-(vinyloxy)-1H-1,2,4-triazole.

14. The method of claim 12 wherein the multi-functional compound is selected from the group consisting of 6-phenylamino-purine, 6-benzylamino-purine, 6-methylamine-purine, 6-dimethyl-purine, 9H-purine-2,6-diamine, α-methyl-N-phenyl-1H-benzotriazole-1-methanamine, 2-(2-aminoethyl)benzimidazole, 2-(2-aminophenyl)-1H-benzimidazole, histamine, 1-methylhistamine, 3-methylhistamine, 1-(3-aminopropyl)imidazole, and 3-amino-pyrazole.

15. The method of claim 6 wherein the multi-functional compound is selected from the group consisting of 1-(trimethylsilyl)-1H-benzotriazole, 1-[(trimethylsilyl)methyl] benzotriazole, 1-(trimethylsilyl) imidazole, and 1-(tert-butyldimethylsilyl) imidazole.
